(19)

**Europäisches Patentamt**

**European Patent Office**

**Office européen des brevets**

(11) **EP 4 675 929 A1**

(12) **EUROPEAN PATENT APPLICATION**

(43) Date of publication:
**07.01.2026 Bulletin 2026/02**

(21) Application number: **25187002.8**

(22) Date of filing: **02.07.2025**

(51) International Patent Classification (IPC):
**H03M 13/11** (2006.01) **H04L 1/00** (2006.01)

(52) Cooperative Patent Classification (CPC):
**H03M 13/116; H03M 13/616; H03M 13/6516;**
H03M 13/1185; H03M 13/255; H04L 1/0057;
H04W 84/12

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **03.07.2024 US 202463667253 P**
**10.06.2025 US 202519233731**
**10.06.2025 US 202519233674**
**10.06.2025 US 202519233703**
**10.06.2025 US 202519233718**

(71) Applicant: **Avago Technologies International**
**Sales**
**Pte. Limited**
**Singapore 768923 (SG)**

(72) Inventors:
 • **Pulikkoonattu, Rethnakaran**
  **Irvine, 92618 (US)**
 • **Blanksby, Andrew**
  **Irvine, 92618 (US)**

(74) Representative: **Dilg, Haeusler, Schindelmann**
**Patentanwaltsgesellschaft mbH**
**Leonrodstraße 58**
**80636 München (DE)**

(54) **SYSTEMS AND METHODS FOR QUASI-CYCLIC LOW DENSITY PARITY CHECK (QC-LDPC) CODE WITH 1/2 CODE RATE**

(57)     An apparatus (105) includes a transmitter (120) and one or more processors (2010). The one or more processors (2010) is configured to identify, according to a code rate of 1/2 and a code block size of 7776 bits, a first binary parity check matrix for a quasi-cyclic-low-density parity-check, QC-LDPC, code, the first binary parity check matrix corresponding to a first exponent matrix. The one or more processors (2010) encode data using the first binary parity check matrix. The transmitter (120) transmits the encoded data.

100

FIG. 1

EP 4 675 929 A1

**Description**

**Cross-Reference to Related Applications**

This application claims the benefit of priority to each of U.S. Provisional Patent Application No. 63/667,253 filed on July 3, 2024, which is incorporated herein by reference in its entirety for all purposes.

**Field of the Disclosure**

This disclosure generally relates to systems and methods for improving an encoding process and/or a decoding process of a communications system using a quasi-cyclic-low-density parity-check (QC-LDPC) code.

**Background**

Error correcting codes enable information data to be exchanged between a transmitter communication system and a receiver communication system in a reliable manner. A transmitter communication system encodes the information data to obtain a codeword. The codeword is encoded information data. The transmitter communication system transmits the codeword to the receiver communication system. Due to noise in the communication channel, the transmission received by the receiver communication system may not be identical to the transmitted codeword. Encoding information data allows a receiver communication system with a proper decoding process to recover the information data from the received transmission despite such noise. For example, the transmitter communication system transmits parity bits to the receiver communication system. The parity bits allow the receiver communication system to verify whether the received transmission is a valid codeword and to correct errors in the transmission if the received transmission is not a valid codeword. In one approach, generating parity bits involves a complex process.

**Brief Description of the Drawings**

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements.

FIG. 1 is a diagram depicting an example communication environment with communication systems, according to one or more embodiments.

FIG. 2 is a schematic block diagram of a computing system, according to an embodiment.

FIG. 3 is a diagram depicting an example exponent matrix, according to one or more embodiments.

FIG. 4 is a diagram depicting example shifted identity matrices for generating a parity check matrix, according to one or more embodiments.

FIG. 5 is a diagram depicting an example parity check matrix, according to one or more embodiments.

FIG. 6 is a diagram depicting an example exponent matrix, according to one or more embodiments.

FIG. 7A and FIG. 7B are diagrams depicting an example exponent matrix and an example binary parity check matrix, according to one or more embodiments.

FIG. 8A to FIG. 8C are diagrams depicting an example exponent matrix, an example binary matrix $\lambda$ (also referred to as "compact matrix" or "$\lambda$ matrix"), and an example binary parity check matrix, according to one or more embodiments.

FIG. 9 is a flow diagram showing a process for encoding data and/or decoding data using an LDPC code, in accordance with an embodiment.

The details of various embodiments of the methods and systems are set forth in the accompanying drawings and the description below.

## Detailed Description

The following disclosure provides many different embodiments, or examples, for implementing different features of the provided subject matter. Specific examples of components and arrangements are described below to simplify the present disclosure. These are, of course, merely examples and are not intended to be limiting. For example, a first feature in communication with or communicatively coupled to a second feature in the description that follows may include embodiments in which the first feature is in direct communication with or directly coupled to the second feature and may also include embodiments in which additional features may intervene between the first and second features, such that the first feature is in indirect communication with or indirectly coupled to the second feature. In addition, the present disclosure may repeat reference numerals and/or letters in the various examples. This repetition is for the purpose of simplicity and clarity and does not in itself dictate a relationship between the various embodiments and/or configurations discussed.

In one aspect, a parity check matrix defines a set of equations that are satisfied by any valid codeword. The parity check matrix may be used for encoding low density parity check ("LDPC") codes, described by Richardson and Urbanke in IEEE Transactions on Information Theory, Vol. 47, No. 2 (February 2001). Generally, many wireless and wireline communication systems use LDPC as a forward error correction coding scheme. However, the longest block length (in bit) for coded data, supported in the 802.11 standards (e.g., 802.11n-802.11be) is 1944. There may be a limited gain in a radio channel (e.g., 2x2 multiple-input and multiple-output channels) that can be achieved using the block length of 1944.

To solve this problem, according to certain aspects, embodiments in the present disclosure relate to a technique to support or provide an LDPC code with the block length of 7776 and the code rate of 1/2. The block length of 7776 is 4 times that of the longest code supported in 802.11n-802.11be standards (e.g., the block length of 1944). In some embodiments, the LDPC code has a quasi-cyclic (QC) structure which helps in efficient encoding and decoding. In some embodiments, QC-LDPC codes may be a class of structured LDPC codes, which may be used in many practical applications including the IEEE 802.11n, 802.11ac, 802.11ax, 802.11be standards. In QC-LDPC codes, a parity check matrix has a cyclic structure that repeats itself in a quasi-cyclic manner, which can simplify the encoding and decoding processes, making QC-LDPC codes more efficient. The code block size (denoted by n) refers to a total number of coded or transmitted bits as a result of encoding data using an error correction code (e.g., LDPC). The number of information bits (denoted by k) refers to a number of bits that carry the data to be subject to the encoding using the error correction code. The code rate (denoted by R) refers to a ratio of the number of information bits to the code block size (R=k/n). In some embodiments, an LDPC encoder may take a block of k bits of information bits (e.g., k=3888) and produce n coded bits with the code rate R=k/n (e.g., R=1/2, n= 7776). An LDPC decoder may operate on (noisy version of ) n received bits and (ideally) recover the k information bits. In some embodiments, the LDPC encoder may take a block of k bits of information bits as input, encode the block of k bits to produce a block of n coded bits (e.g., n= 7776) with the code rate 1/2 (R=k/n).

Generally, a parity check matrix for a code represents equations that determine whether errors have occurred during transmission. More formally, for all valid codewords (i.e., bits produced by the encoder with no errors), the following equation can be true:

$$\mathbf{Hc}{=}\mathbf{0} \ \ldots\ldots\ldots\ldots\ (Equation\ 1)$$

In Equation 1, "**H**" is the parity check matrix, "**c**" is a codeword vector, and "**0**" is a vector of all zeroes. The parity check matrix, **H**, is one way of describing a code.

A generator matrix for a code, **G**, satisfies the following equation:

$$\mathbf{sG}{=}\mathbf{c} \ \ldots\ldots\ldots\ldots\ (Equation\ 2)$$

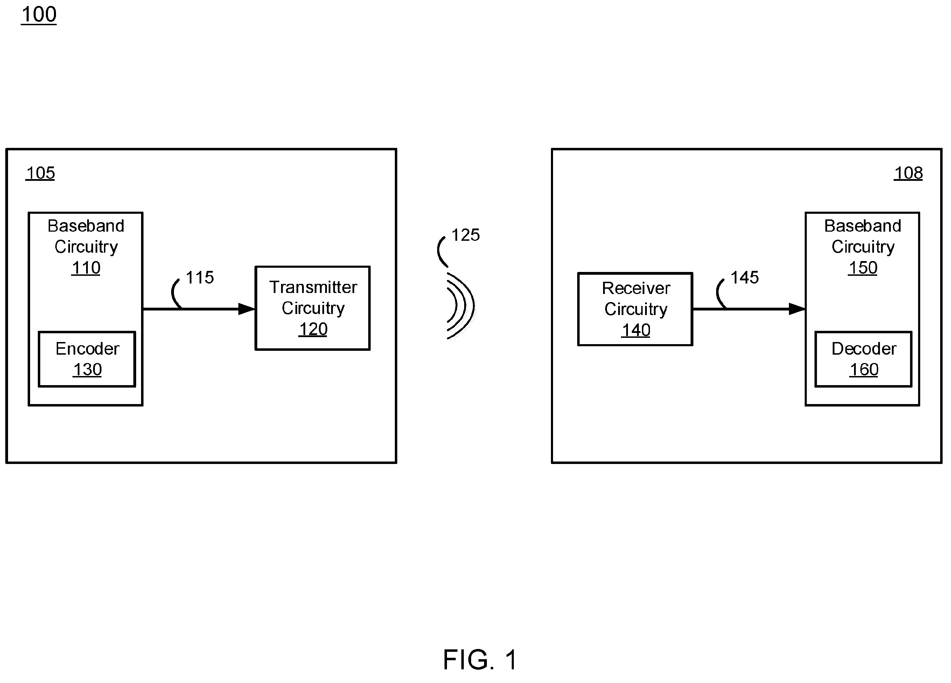

In Equation 2, "**s**" is a vector of information bits, "**G**" is a generator matrix and "**c**" is the codeword that corresponds to "**s**." In some embodiments, a system (e.g., a communication system 108 including a decoder 160 in FIG. 1) can decode the codeword c to obtain the decoded data s using Equation 2.

The parity check and generator matrices for a code are related per the above matrix equations. Generally, if a parity check matrix is low density, the corresponding generator matrix will be high density, and vice versa. LCPC codes are accordingly characterized by low density parity check matrices and high density generator matrices. The density of a matrix relates to the number of operations that must be performed to implement one of the above equations. Although it was recognized by 1995 that LDPC codes could be used to transmit data with very few errors, i.e., with error rates as good or better than turbo codes, one disadvantage of LDPC codes is that their generator matrices were high density and that made encoding computationally intensive, rendering the codes impractical for many applications.

In some implementations, a parity check matrix may have a quasi-cyclic structure, for example, a parity check matrix for QC-LDPC code (n= 7776, k=3888, R=1/2). Given a lifting size z, the parity check matrix may have a plurality of sub-matrices such that each submatrix is cyclically shifted version of an identity matrix of size (z x z), where z=162, for example. A parity check matrix can be represented in two equivalent forms: (1) parity check matrix H and (2) a block matrix or an exponent matrix P=E(H).

In some implementations, a parity check matrix H may be a binary matrix whose size is m x n (each of m and n is an integer). Elements of the parity check matrix are binary values. Given a block length n and a code rate R, an LDPC code (or QC-LDPC code) LDPC (n, R) satisfies the following equations:

$$k=nR \ldots\ldots\ldots\ldots\ldots \text{(Equation 3)}$$

$$m=n(1-R) \ldots\ldots\ldots\ldots\ldots \text{(Equation 4)}$$

In some implementations, a block matrix or an exponent matrix (QC-LDPC exponent matrix) may be obtained. Given a lifting size z, the exponent matrix P=E(H) may have a size of m/z x n/z. If n=24z (e.g., n= 7776, z=324), then the size of P=E(H) is 24(1-R) x 24 (= n(1-R)/z x n/z). Elements of the exponent matrix may be integer values which correspond to cyclic shift values of identity matrix of size z x z. A parity check matrix H may be a sparse binary matrix that can be derived from an exponent matrix P=E(H). The generator matrix G may have a size n x k in binary form (e.g., elements of the generator matrix G are binary values). The exponent matrix P=E(H) may have a structure including a plurality of sub-matrices (e.g., A, B, C, D, E, T).

In some implementations, a binary QC-LDPC code LDPC (n, R) may be characterized by the null space of an n(1-R)×n parity check matrix H. The parity check matrix H may be a binary sparse matrix which includes a set of circulant matrices of size z x z. The parity-check matrix H of a QC-LDPC code can be represented equivalently by an exponent matrix P=E(H). This representation can help to illustrate the graphical structure of the underlying code as a base graph along with coefficient of shifting.

In some implementations, a parity check matrix H may be generated from an exponent matrix P=E(H). The exponent matrix P=E(H) may include (as elements) shift values d in the range 0<=d<z along with d=-1. For example, if z=7, the shift values d may include -1, 0, 1, 2, 3, 4, 5, 6. The shift value d=0 may correspond (or map) to an identity matrix of size z x z, denoted by I(z). The shift value d=-1 may correspond (or map) to a null matrix (all elements zero) of size z x z, denoted by 0*I(z). Any other integer value d in [1,z-1] may correspond (or map) to a matrix cyclically right shifted from I(z). The parity check matrix H can be obtained from the exponent matrix P=E(H) by expanding the exponent matrix P such that each element of the exponent matrix P (as a shift value d) is replaced by a matrix corresponding to the shift value.

In some implementations, the exponent matrix P=E(H) may include a plurality of elements P1,1, P1,2, P1,3, ..., P1,ń; P2,1, P2,2, P2,3, ..., P2,ń; ..., P1,1, P1,2, P1,3, ..., Pḿ,ń, which correspond to (ḿ x ń) values where ḿ and ń satisfy the following equations:

$$\acute{m}= n(1-R)/z \ldots\ldots\ldots\ldots\ldots \text{(Equation 5)}$$

$$\acute{n} = n/z \ldots\ldots\ldots\ldots\ldots \text{(Equation 6)}$$

The exponent matrix (or permutation matrix) P=E(H) may be expressed as following:

$$P \equiv E(H) = \begin{pmatrix} P_{1,1} & P_{1,2} & P_{1,3} & \cdots & \cdots & P_{1,\acute{n}} \\ P_{2,1} & P_{2,2} & P_{2,3} & \cdots & \cdots & P_{2,\acute{n}} \\ \cdots & \ddots & \ddots & \cdots & \cdots & \vdots \\ P_{\acute{m},1} & P_{\acute{m},2} & P_{\acute{m},3} & \cdots & \cdots & P_{\acute{m},\acute{n}} \end{pmatrix} \ldots\ldots\ldots\ldots \text{(Equation 7)}$$

The corresponding parity check matrix H may be obtained by replacing each element of the matrix (as a shift value d) by a matrix C(d) corresponding to the shift value as follows:

$$H = \begin{pmatrix} C(P_{1,1}) & C(P_{1,2}) & C(P_{1,3}) & \dots & \dots & C(P_{1,\acute{n}}) \\ C(P_{2,1}) & C(P_{2,2}) & C(P_{2,3}) & \dots & \dots & C(P_{2,\acute{n}}) \\ \dots & \ddots & \ddots & \dots & \dots & \vdots \\ C(P_{\acute{m},1}) & C(P_{\acute{m},2}) & C(P_{\acute{m},3}) & \dots & \dots & C(P_{\acute{m},\acute{n}}) \end{pmatrix} \dots\dots\dots (\text{Equation 8})$$

For example, a matrix C(1) may be expressed as follows:

$$C(1) = \begin{pmatrix} 0 & 1 & 0 & \dots & \dots & 0 \\ 0 & 0 & 1 & \dots & \dots & \ddots \\ \ddots & \ddots & \ddots & \dots & \dots & \vdots \\ 0 & 0 & 0 & \dots & \dots & 1 \\ 1 & 0 & 0 & \dots & \dots & 0 \end{pmatrix} \dots\dots\dots (\text{Equation 9})$$

In some implementations, an encoder can produce codewords using a generator matrix (e.g., using Equation 2). In some embodiments, an encoder can use the parity check matrix (rather than the generator matrix) to produce codewords from vectors of information bits. After a parity check matrix H is obtained, the parity check matrix H may have sub-matrices A, B, C, D, T, E. An upper area O of the sub-matrix T may correspond to an area in which the matrix contains all zeroes, and the other areas may represent locations that can contain ones.

In some implementations, the codeword c can be obtained by the following expression:

$$c = [s\ p1\ p2] \dots\dots\dots (\text{Equation 10}),$$

where "s" is the vector of information bits to be encoded, "$p_1$" is a vector of the first g parity bits and "$p_2$" is a vector of the remaining m-g parity bits.

The vectors p1 and p2 can be obtained by the following equations:

$$\Phi = -ET^{-1}B+D \dots\dots\dots (\text{Equation 11});$$

$$p_1^T = -\Phi^{-1}(-ET^{-1}A+C)\ s^T \dots\dots\dots (\text{Equation 12});$$

and

$$p_2^T = -T^{-1}(As^T+Bp_1^T) \dots\dots\dots (\text{Equation 13}).$$

Although various embodiments disclosed herein are described for encoding data for a wireless communication (e.g., wireless local area network (WLAN) conforming to any IEEE 802.11 standard), principles disclosed herein are applicable to other types of communication (e.g., wired communication) or any process that performs encoding for LDPC codes.

In some implementations, a system and/or a method can generate LDPC codes having code rate of 1/2 using Khatri-Rao lifting (e.g., using Khatri-Rao product). For example, the system can use a base LDPC code (as mother code) to recursively construct LDPC codes having a block length that is double the block length of the base LDPC code. The mother code can be defined by a parity check matrix H or an exponent matrix P=E(H) as in QC-LDPC code. Each entry in P may be an integer value, corresponding to a cyclic shift value of an identity matrix of size z x z.

In some implementations, the system can determine (e.g., calculate, compute, obtain) a binary matrix Γ, which has the same size (or dimension) as P=E(H). The binary matrix Γ may internally include sub-matrices which are powers of

$$J(2)=\begin{pmatrix} 0 & 1 \\ 1 & 0 \end{pmatrix}$$

exchange matrix , e.g., an exchange matrix of order 2. The matrix $\Gamma$ whose non-zero values (1) may be randomized such that the rank of the binary matrix maintains to be full rank while the binary matrix conforms to good LDPC code performances (e.g., achieving low packet error rates). The system can perform a computer search (e.g., search using one or more processors) to identify the most optimal $\Gamma$ that can yield the least packet error performance (e.g., packet error rate (PER)). For example, the matrix $\Gamma$ can maintain to have full rank, which equals 24(1-R), for a Wi-Fi code with code rate R. For example, for a code rate of R=1/2, the binary matrix $\Gamma$ may have a dimension of 12x24 (12 rows, 24 columns) and have full rank of 12 (=24(1-1/2)). The rank of a matrix refers to a maximal number of linearly independent columns of the matrix or a dimension of the vector space generated by the columns of the matrix.

In some implementations, LDPC codes generated (e.g., constructed, created) using a Khatri-Rao lifting scheme can be used to design Wi-Fi LDPC codes of block length= 7776 bits from existing LDPC codes of block length=3888 bits.

Khatri-Rao product is an extension to the operation of block wise Kronecker products when the involved matrices are suitably partitioned. Khatri-Rao product can be defined as follows. Consider two matrices A, B of orders (dimensions or sizes) u × v and p × q, respectively. In compart form, $A = (a_{i,j})$ and $B = (b_{k,l})$. Further let $A = (A_{i,j})$ be partitioned with $A_{i,j}$ of order $u_i \times v_j$ as (i, j)$^{th}$ sub-matrix block, and $B = (B_{i,j})$ be partitioned with $B_{i,j}$ of order $p_k \times q_l$ as (k, l)$^{th}$ sub-matrix block, where $\Sigma_i\, u_i = u,\ \Sigma_j\, v_j = v,\ \Sigma_k\, p_k = p,\ \Sigma_l\, q_l = q$. Khatri-Rao product operation of two matrices A and B can be defined as follows:

$$A \circledast B = \left(A_{i,j} \otimes B_{i,j}\right)_{i,j} \ldots\ldots\ldots\ldots \text{(Equation 14)}$$

where $\circledast$ is the Khatri-Rao product operation, $A_{i,j} \otimes B_{i,j}$ is the Kronecker product of order $u_i p_i \times v_j q_j$ and the overall output $A \circledast B$ has order $\Sigma_i\, u_i p_i \times \Sigma_j\, v_j q_j$. Extension to block wise Kronecker products when the involved matrices can be well partitioned. An example of calculating Khatri-Rao product is shown as follows. Let

$$A = \begin{pmatrix} 1 & 0 & 2 & 7 \\ 3 & 6 & 2 & 3 \end{pmatrix}$$

$$B = \begin{pmatrix} -1 & -2 & 5 & 9 & 9 & 2 & 8 & 1 \\ 5 & 1 & 0 & 4 & 3 & 8 & 9 & 3 \\ 3 & -1 & 8 & 8 & 3 & 9 & 0 & 2 \\ 2 & 0 & 9 & 3 & 9 & 1 & 6 & 5 \end{pmatrix}$$

Then, with $u_i = 1$, $v_i = 1$, $1 \leq i \leq 2$, $1 \leq j \leq 4$ and $p_k = q_l = 2$, $1 \leq k \leq 2$, $1 \leq l \leq 4$, the Khatri-Rao product of A and B is given by

$$A \circledast B = \begin{pmatrix} -1 & -2 & 0 & 0 & 18 & 4 & 56 & 7 \\ 5 & 1 & 0 & 0 & 6 & 16 & 63 & 21 \\ 9 & -3 & 48 & 48 & 6 & 18 & 0 & 6 \\ 6 & 0 & 54 & 18 & 18 & 2 & 18 & 15 \end{pmatrix}$$

In some embodiments, the system can perform (e.g., calculate, compute) Khatri-Rao lifting as follows. Let $P \equiv E(H)$ be an exponent matrix corresponding to a parity check matrix H of a QC-LDPC code. The exponent matrix may include integer values between -1, 0, ..., z-1 where z is a design parameter of the code. For block length of 1944, the system may use z=81 for Wi-Fi error correction codes. The parity check matrix H can be obtained from the P matrix, by cyclic shifting identity matrix $\mathbb{I}^{Z \times Z}$ by the constituent entries of P. The system can determine (e.g., calculate, compute, obtain) a new code matrix $\acute{P}$ using Equation 15 as follows.

$$H' = H \circledast J^{\odot\Gamma} - J^{\odot(\mathbb{1}_{uxv} - \Gamma)} \ldots\ldots\ldots\ldots \text{(Equation 15)}.$$

where $\circledast$ is the Khatri-Rao product operation, $\Gamma$ is a binary matrix, $\mathbb{1}$ is the all one matrix whose order (dimension or size) is the same as the Γ matrix (e.g., u × v), and $J = J(2) = \begin{pmatrix} 0 & 1 \\ 1 & 0 \end{pmatrix}$ is called the exchange matrix of order 2. ⊙ is an operation involving matrix exponent defined as follows:

$$A^{\odot \mathbf{B}} \triangleq \left( A^{\mathbf{B}_{i,j}} \right)_{i=1:u, j=1:v} , B \in \mathbb{F}_2^{u \times v} \ldots\ldots\ldots \text{ (Equation 16)}.$$

where B has a dimension of (u × v).

In some implementations, the system can generate (e.g., calculate, compute, obtain) a (new) parity check code by calculating a Khatri-Rao product of a parity check matrix (of size m x n) of a base code and a binary (random) matrix Γ (using Equation 16). In some implementations, the system may determine the binary matrix Γ by iteratively changing an entry of the matrix and finding one or more best matrices in terms of the number of shortest loops and/or packet error performance.

In some implementations, the system can define (e.g., calculate, compute, obtain, generate) the base code as a parity check matrix H or an exponent matrix E(H) as in QC-LDPC code. The system can calculate (e.g., generate, compute, obtain, determine) the binary matrix Γ, which has the same size as E(H). In some implementations, if H is chosen as the representation of the parity check matrix, the matrix Γ can have the same size as H. The matrix Γ can internally include sub-matrices which are powers of exchange matrix J(2). The binary matrix Γ whose non-zero values (e.g., value "1") can be randomized such that the resulting matrix conforms to good LDPC code performances (e.g., packet error performance). For example, the system can randomize non-zero values of the binary matrix Γ (which has a dimension of (u × v)) such that the matrix Γ can maintain full rank which equals min (u,v)=24(1-R), for Wi-Fi error correction codes with a code rate of R. In some embodiments, the system can validate a binary Γ matrix from a given parity check matrix and a base matrix. For example, the system can validate a binary Γ matrix based on performance of the a given parity check matrix and the base matrix. In some embodiments, the binary Γ matrix can be any binary matrix Γ which are full rank. A matrix (say matrix A) is full rank if the rank of the matrix A is the highest possible for a matrix of the same size as the matrix A.

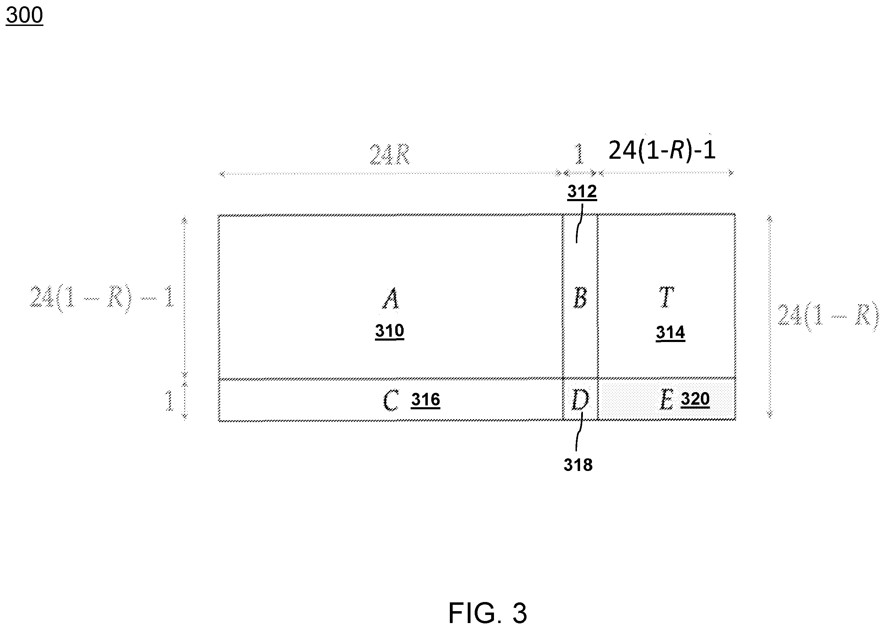

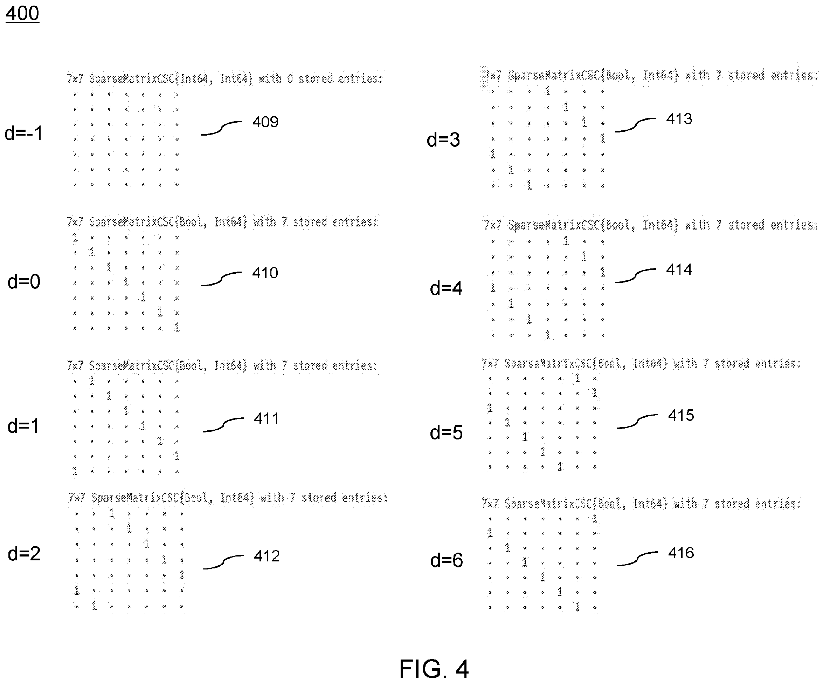

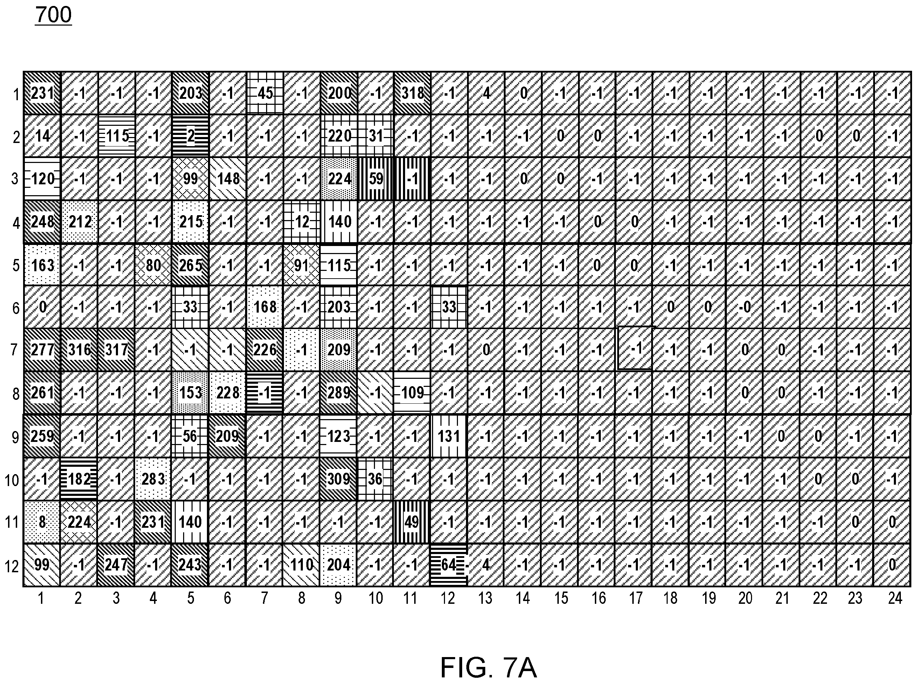

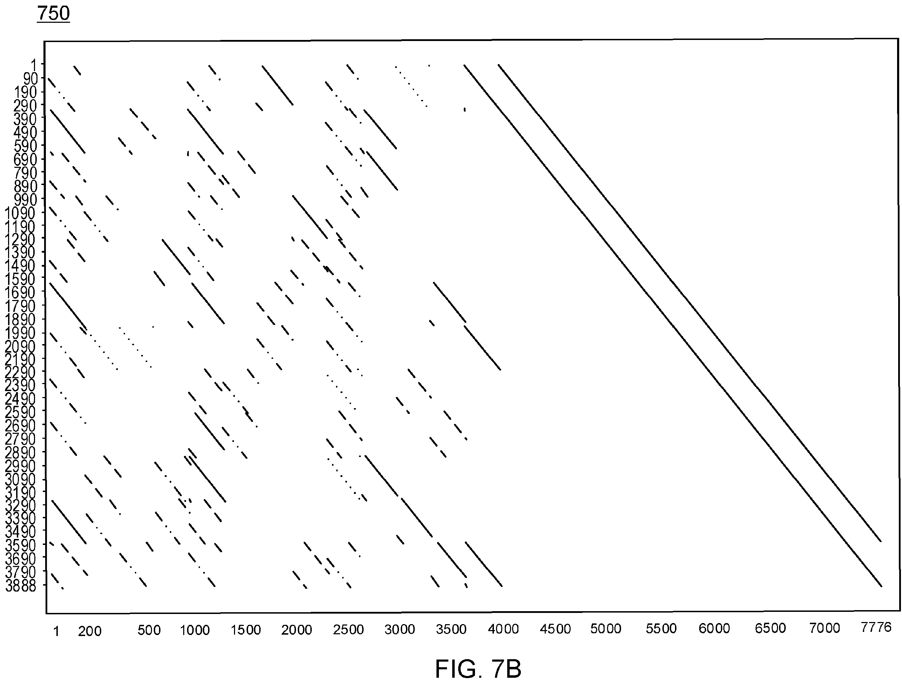

In some implementations, the system can define, generate, or create a new Quasi Cyclic (QC)-LDPC codebook of blocklength n = 7776 bits, rate R= 1/2, and information length k = 1/2*7776 =3888 bits. The system can define, generate, or create a parity check matrix H (see FIG. 7B) which has size = (1-R)*n x n = 1296 x 7776. The system can define, generate, or create an exponent matrix E(H) (see FIG. 7A) which is equivalent to H. E(H) has size 24*(1-R) x 24 and contains cyclic shift values such that each of the entries gets mapped to circulant matrix of size Z=324 (see FIG. 3). Elements of E(H) are integers between -1 and Z-1 (Z=324). The codebook can be defined in terms of E(H). E(H) can be mapped to H using Equations 7-9 as shown FIG. 4. The new QC-LDPC code of blocklength n = 7776 bits and rate R= 1/2 has the following code properties: (1) the code graph corresponding to the code has optimized to achieve a lowest girth, yielding a lowest error floor; and (2) the decoding threshold is within 2dB of random linear codes in AWGN channels.

In some implementations, the system can perform encoding of data either using the parity check matrix (see FIG. 7B) using methods such as direct encoding, resource unit (RU) encoding or its variants. Here, "RU encoding" refers to a method where different RUs within a channel can use different modulation and coding schemes (e.g., QAM levels and LDPC code rates) to adapt to varying channel conditions. In some implementations, the system can encode data using the equivalent generator matrix G according to Equation 2. The generator matrix G can be equivalent to parity check matrix H and can be in the null space of H.

In some implementations, the system can perform decoding of data using message passing based algorithms. In some implementations, the system can use a sub-structure for parallel and/or concurrent decoding.

In some implementations, the system can decompose a (n=7776, k=3888) QC-LDPC code (e.g., a parity check matrix or an exponent matrix) as product lifted (3888, 1944) codes. Using a compact matrix λ, the system can treat the parity check matrix as a product of two lifted codes (n=3888, k=1944). Let P be an exponent matrix corresponding to the (3888, 1944) code. The compact matrix λ and the exponent matrix P can have the same size 24*(1-R) x 24 (see FIG. 3).

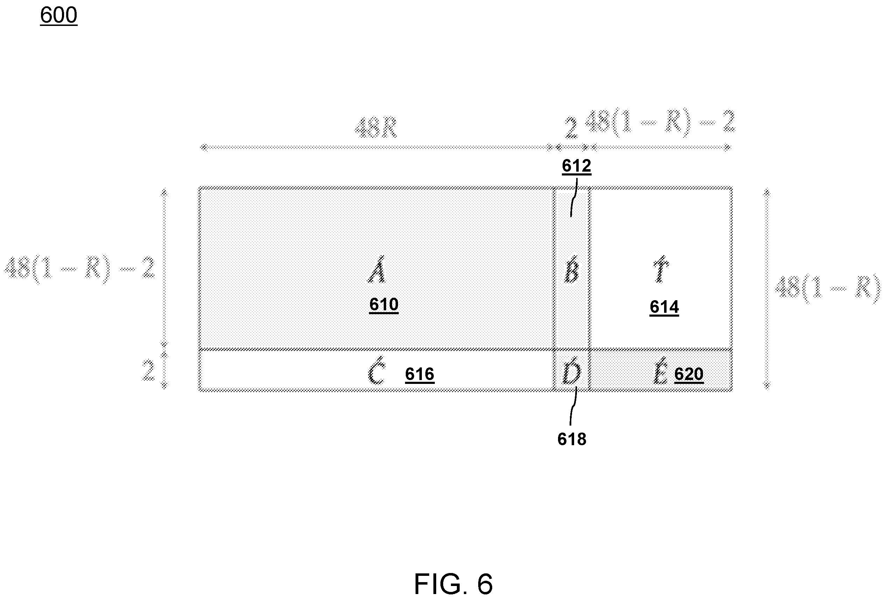

In some implementations, given a first QC-LDPC code of (n=7776, k=3888), the system can identify, find, obtain, or calculate a second QC-LDPC code of (n=7776, k=3888) which is a Khatri-Rao product of a parity check matrix of a (3888, 1944) base code and a binary matrix Γ (see Equation 16). This process can help to decompose the parity check matrix for the first QC-LDPC code (referred to as "first parity check matrix") to two existing codes of blocklength=3888 and thus provide means to perform parallel encoding/decoding. The exponent matrix for the second QC-LDPC code (referred to as "second exponent matrix") can have size 48*(1-R) x 48 and contains cyclic shift values such that each of the entries gets mapped to circulant matrix of size Z=324/2= 162=2*81 (see FIG. 6). It is noted that Z=81 is the value specified in IEEE 802.11n. The parity check matrix for the second QC-LDPC code (referred to as "second parity check matrix") can be different from the parity check matrix for the first QC-LDPC code (first parity check matrix), but both the overall graph structure and performance can be similar to each other.

Mathematically, for each element $d \in E1(H)$ (which is the first exponent matrix for the first QC-LDPC code), a 2x2 submatrix can be replaced with, where the mapping goes as follows:

$$d \;\rightarrow\; \left\lfloor \frac{d}{2} \right\rfloor \begin{pmatrix} 0 & 1 \\ 1 & 0 \end{pmatrix}^{\bmod\,(d,2)} - \begin{pmatrix} 0 & 1 \\ 1 & 0 \end{pmatrix}^{1+d} \qquad \text{............ (Equation 17);}$$

and

$$\text{the corresponding } \lambda(d) \rightarrow mod(d,2) \text{ ............ (Equation 18).}$$

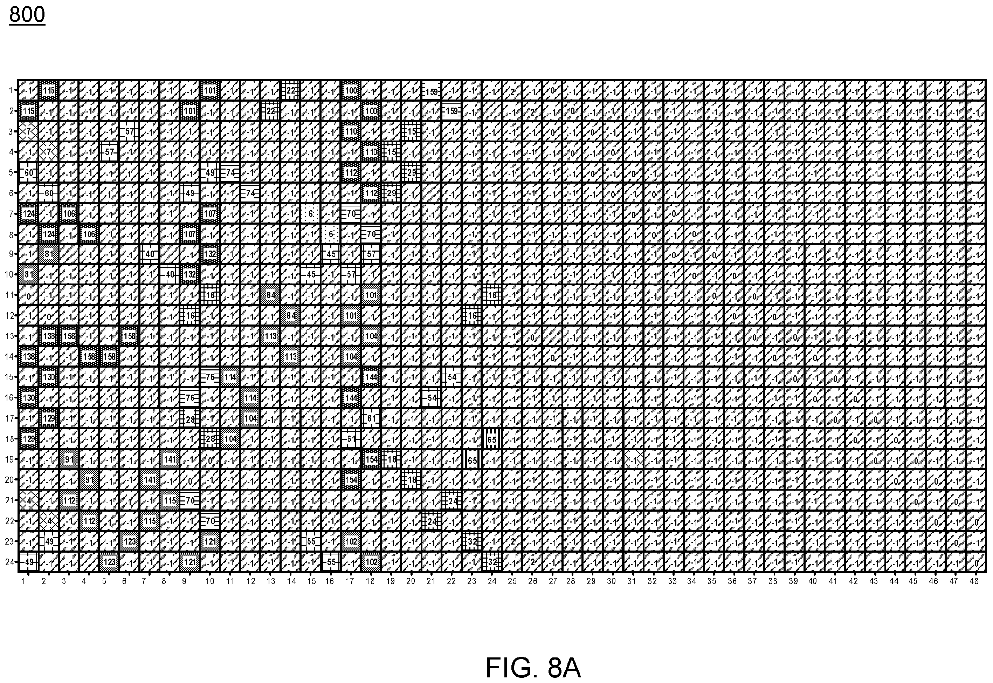

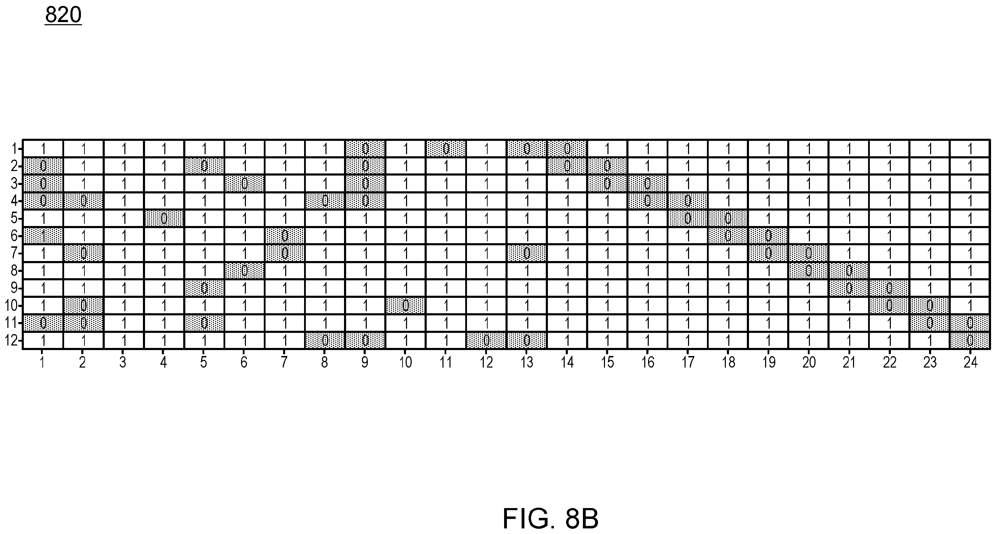

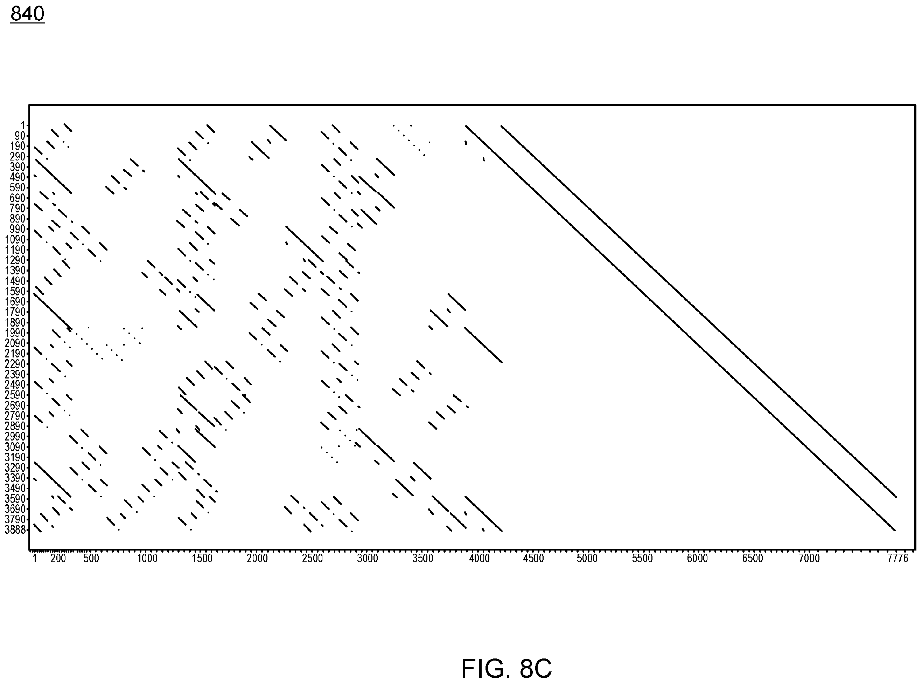

In some implementations, given the first exponent matrix E(H) (referred to as "E1(H)"), the system can apply the above mapping (Equation 17 and Equation 18) to E1(H) to obtain the second exponent matrix E(H) (referred to as "E2(H)") and the compact matrix $\lambda$. Examples of first exponent matrix, second exponent matrix, and compact matrix $\lambda$ are shown in FIG. 7A, FIG. 8A, and FIG. 8B, respectively.

In some implementations, given the first QC-LDPC code, the system can homomorphically re-arrange E(H) and H matrices for the first QC-LDPC code (referred to as "E1(H)" and "H1" respectively) to obtain E(H) and H matrices for a second QC-LDPC code (referred to as "E2(H)" and "H2" respectively). The system can re-arrange the matrix E1(H) such that the position of one, more or all of the elements or sub-matrices is moved around in such a way that the re-arranged matrix E2(H) contains the same element as E1(H). In some implementations, given E1(H) has size m×n (m, n are positive integers), the system can re-arrange the matrix E1(H) to obtain the re-arranged matrix E2(H) using the following equation:

$$E2(H) = A * E(H) * B \text{ ............ (Equation 19),}$$

where A * E(H) * B is also a valid matrix, where A and B are permutation matrices of size m×m and n×n, respectively. Permutation matrices A and B are binary matrices (i.e., entries 0 and 1 only), whose inverses are simply the transpose as follows:

$$\mathrm{inv}(A) = \mathrm{transpose}(A); \text{ and } \mathrm{inv}(B) = \mathrm{transpose}(B) \text{ ............ (Equation 20).}$$

Similarly, the parity check matrix H2 may be re-arranged subject to homomorphism and still keep the same decoding properties as those of parity check matrix H1. The mapping shown in Equation 17 and Equation 18 is a special case where the permutation is done in the form of single exchange matrix operation.

In some implementations, an apparatus may include a transmitter and one or more processors. The one or more processors may be configured to identify, according to a code rate of 1/2 and a code block size of 7776 bits, a first binary parity check matrix for a quasi-cyclic-low-density parity-check (QC-LDPC) code, the first binary parity check matrix corresponding to a first exponent matrix. The one or more processors may be configured to encode data using the first binary parity check matrix. The transmitter may be configured to transmit the encoded data.

In some implementations, the first exponent matrix may have 1152 values. The one or more processors may be further configured to generate the first exponent matrix based at least on a second exponent matrix having 288 values. In generating the first exponent matrix, the one or more processors may be configured to replace each value of the second exponent matrix with a (2x2) matrix. In some implementations, the first exponent matrix may be generated based at least on the second exponent matrix according to a binary matrix. The binary matrix may include the following set of values: [1 1 1 1 1 1 1 0 1 0 1 0 0 1 1 1 1 1 1 1 1 0 1 1 0 1 1 0 1 1 1 0 0 1 1 1 1 1 1 1 0 1 1 1 0 1 1 0 1 1 1 1 0 0 1 1 1 1 1 1 1 0 0 1 1 1 1 1 0 0 1 1 1 1 1 1 0 0 1 1 1 1 1 1 1 1 0 1 1 1 1 1 1 1 1 1 1 0 0 1 1 1 1 1 1 0 1 1 1 1 0 1 1 1 1 0 1 1 1 1 1 1 1 0 0 1 1 1 1 1 0 1 1 1 0 1 1 1 1 0 1 1 1 1 1 0 0 1 1 1 1 1 1 1 0 1 1 1 1 1 1 1 1 1 1 1 0 0 1 1 1 1 1 1 1 0 1 1 1 0 1 1 1 1 1 1 0 1 1 1 1 1 1 1 1 0 0 1 0 0 1 0 0 1 1 1 1 1 1 1 1 1 0 0 1 1 1 1 1 1 1 0 0 1 1 0 0 1 1 1 1 1 1 1 1 1 0].

In some implementations, the first exponent matrix may include the following set of values: [-1 115 -1 -1 -1 -1 -1 -1 -1 101 -1 -1 -1 22 -1 -1 100 -1 -1 159 -1 -1 2 -1 0 -1 -1 -1 -1 -1 -1 -1 -1 -1 -1 -1 -1 -1 -1 -1 -1 -1 -1 115 -1 -1 -1 -1 -1 -1 101 -1 -1 -1 22 -1 -1 -1 100 -1 -1 159 -1 -1 2 -1 0 -1 -1 -1 -1 -1 -1 -1 -1 -1 -1 -1 -1 -1 -1 -1 -1 -1 7 -1 -1 -1 57 -1 -1 11 -1 -1 -1 -1 -1 -1 110 -1 -1 15 -1 -1 -1 -1 -1 0 -1 0 -1 -1 -1 -1 -1 -1 -1 -1 -1 -1 -1 -1 -1 -1 -1 7 -1 -1 57 -1 -1 -1 11 -1 -1 -1 -1 -1 -1 110 15 -1 -1 -1 -1 -1 -1 0 -1 0 -1 -1 -1 -1 -1 -1 -1 -1 -1 -1 -1 -1 -1 -1 -1 60 -1 -1 -1 -1 -1 -1 49 74 -1 -1 -1 -1 -1 112 -1 -1 29 -1 -1 -1 -1 -1 -1 -1 0 -1 0 -1 -1 -1 -1 -1 -1 -1 -1 -1 -1 -1 -1 -1 -1 -1 60 -1 -1 -1 -1 -1 49 -1 -1 74 -1 -1 -1 -1 -1 112 29 -1 -1 -1 -1 -1 -1 -1 -1 -1 0 -1 0 -1 -1 -1 -1 -1 -1 -1 -1 -1 -1 -1 -1 -1 -1 -1 124 -1 106 -1 -1 -1 -1 -1 -1 107 -1 -1 -1

-16 -1 70 -1 -1 -1 -1 -1 -1 -1 -1 -1 -1 -1 -1 0 -1 0 -1 -1 -1 -1 -1 -1 -1 -1 -1 -1 -1 -1 -1 -1 -1 -1 124 -1 106 -1 -1 -1 107 -1 -1 -1 -1 -1
-16 -1 70 -1 -1 -1 -1 -1 -1 -1 -1 -1 -1 -1 -1 0 -1 0 -1 -1 -1 -1 -1 -1 -1 -1 -1 -1 -1 -1 -1 -1 81 -1 -1 -1 -1 40 -1 -1 132 -1 -1 -1 -1 -1
45 -1 57 -1 -1 -1 -1 -1 -1 -1 -1 -1 -1 -1 -1 0 -1 0 -1 -1 -1 -1 -1 -1 -1 -1 -1 -1 -1 -1 81 -1 -1 -1 -1 -1 40 132 -1 -1 -1 -1 -1 45 -1
57 -1 -1 -1 -1 -1 -1 -1 -1 -1 -1 -1 -1 -1 -1 0 -1 0 -1 -1 -1 -1 -1 -1 -1 -1 -1 -1 -1 0 -1 -1 -1 -1 -1 -1 16 -1 -1 84 -1 -1 -1 -1 1 101
-1 -1 -1 -1 -1 16 -1 -1 -1 -1 -1 -1 -1 -1 -1 0 -1 0 -1 -1 -1 -1 -1 -1 -1 -1 -1 -1 -1 0 -1 -1 -1 -1 -1 16 -1 -1 -1 84 -1 1 101 -1 -1 -1
-1 -1 16 -1 -1 -1 -1 -1 -1 -1 -1 -1 -1 -1 -1 0 -1 0 -1 -1 -1 -1 -1 -1 -1 -1 -1 -1 138 158 -1 -1 158 -1 -1 -1 -1 -1 113 -1 -1 -1 -1 104 -1
-1 -1 -1 -1 -1 0 -1 -1 -1 -1 -1 -1 -1 -1 -1 0 -1 0 -1 -1 -1 -1 -1 -1 -1 -1 138 -1 -1 158 158 -1 -1 -1 -1 -1 -1 113 -1 -1 104 -1 -1 -1 -1
-1 -1 -1 -1 -1 0 -1 -1 -1 -1 -1 -1 -1 -1 -1 0 -1 0 -1 -1 -1 -1 -1 -1 -1 130 -1 -1 -1 -1 -1 -1 76 114 -1 -1 -1 -1 -1 144 -1 -1 -1 -1 -1
-1 54 -1 -1 -1 -1 -1 -1 -1 -1 -1 -1 -1 -1 -1 -1 0 -1 0 -1 -1 -1 -1 -1 -1 -1 130 -1 -1 -1 -1 -1 -1 76 -1 -1 114 -1 -1 -1 144 -1 -1 -1 -1
54 -1 -1 -1 -1 -1 -1 -1 -1 -1 -1 -1 -1 -1 -1 -1 0 -1 0 -1 -1 -1 -1 -1 -1 -1 129 -1 -1 -1 -1 -1 -1 28 -1 -1 104 -1 -1 -1 -1 161 -1 -1 -1
-1 -1 165 -1 -1 -1 -1 -1 -1 -1 -1 -1 -1 -1 -1 -1 -1 0 -1 0 -1 -1 -1 -1 -1 -1 129 -1 -1 -1 -1 -1 -1 28 104 -1 -1 -1 -1 161 -1 -1 -1 -1 -1
65 -1 -1 -1 -1 -1 -1 -1 -1 -1 -1 -1 -1 -1 -1 -1 -1 0 -1 0 -1 -1 -1 -1 -1 -1 91 -1 -1 -1 141 -1 0 -1 -1 -1 -1 -1 -1 154 18 -1 -1 -1 -1
-1 -1 -1 -1 -1 -1 -1 -1 -1 -1 -1 -1 -1 -1 -1 -1 -1 0 -1 0 -1 -1 -1 -1 -1 -1 91 -1 -1 141 -1 0 -1 -1 -1 -1 -1 -1 154 -1 -1 18 -1 -1 -1 -1
-1 -1 -1 -1 -1 -1 -1 -1 -1 -1 -1 -1 -1 -1 -1 -1 -1 0 -1 0 -1 -1 14 -1 1112 -1 -1 -1 1115 70 -1 -1 -1 -1 -1 -1 -1 -1 -1 -1 -1 24 -1 -1 -1 -
1 -1 -1 -1 -1 -1 -1 -1 -1 -1 -1 -1 -1 -1 -1 -1 -1 -1 0 -1 0 -1 -1 14 -1 1112 -1 1115 -1 1 70 -1 -1 -1 -1 -1 -1 -1 -1 -1 24 -1 -1 -1 -1 -1
-1 -1 -1 -1 -1 -1 -1 -1 -1 -1 -1 -1 -1 -1 -1 -1 -1 -1 0 -1 0 -1 149 -1 -1 1123 -1 -1 1121 -1 -1 -1 -1 55 -1 102 -1 -1 -1 -1 32 -1 2 -1 1
-1 -1 -1 -1 -1 -1 -1 -1 -1 -1 -1 -1 -1 -1 -1 -1 -1 -1 0 -1 49 -1 -1 1123 -1 -1 1121 -1 -1 -1 -1 -1 55 -1 102 -1 -1 -1 -1 32 -1 2 -1
-1 -1 -1 -1 -1 -1 -1 -1 -1 -1 -1 -1 -1 -1 -1 -1 -1 -1 -1 0 ].

In some implementations, the first exponent matrix may include the following set of values: [231 -1 -1 -1 203 -1 45 -1 200 -1 318 -1 40 -1 -1 -1 -1 -1 -1 -1 -1 -1 14 -1 1115 -1 2 -1 -1 -1 220 31 -1 -1 -1 0 0 -1 -1 -1 -1 -1 -1 -1 -1 120 -1 -1 -1 99 148 -1 -1 224 59 -1 -1 -1 -1 0 0 -1 -1 -1 -1 -1 -1 -1 248 212 -1 -1 215 -1 -1 1 12 140 -1 -1 -1 -1 -1 0 0 -1 -1 -1 -1 -1 -1 163 -1 -1 1 80 265 -1 -1 91 115 -1 -1 -1 -1 -1 -1 -1 0 0 -1 -1 -1 -1 -1 -1 0 -1 -1 1 33 -1 1 168 -1 203 -1 -1 1 33 -1 -1 -1 -1 -1 0 0 -1 -1 -1 -1 -1 277 316 317 -1 -1 -1 226 -1 209 -1 -1 -1 0 -1 -1 -1 -1 -1 0 0 -1 -1 -1 -1 261 -1 -1 -1 1 153 228 -1 -1 1289 -1 109 -1 -1 -1 -1 -1 -1 -1 0 0 -1 -1 -1 259 -1 1 -1 1 56 209 -1 -1 1123 -1 -1 1131 -1 -1 -1 -1 -1 -1 -1 0 0 -1 -1 -1 182 -1 283 1 -1 -1 -1 309 36 -1 -1 -1 -1 -1 -1 -1 -1 -1 -1 0 0 -1 8 224 -1 231 140 -1 -1 -1 -1 149 -1 -1 -1 -1 -1 -1 -1 1 -1 -1 -1 0 0 99 -1 247 -1 243 -1 -1 110 204 -1 -1 64 4 -1 -1 -1 -1 -1 -1 -1 -1 -1 -1 0].

In some implementations, the one or more processors may be further configured to generate the first exponent matrix by re-arranging a third exponent matrix having the same dimensions as the first exponent matrix. The third exponent matrix may be re-arranged such that a position of one or more elements or one or more submatrices is changed and the re-arranged third exponent matrix contains the same elements as the first exponent matrix.

In some implementations, the first exponent matrix may have dimensions of m x n where each of m and n is a positive integer. The one or more processors may be further configured to generate the first exponent matrix by performing the following matrix multiplication: A*E(H)*B where A is a permutation matrix having dimensions of m x m, B is a permutation matrix having dimensions n x n, and E(H) is a fourth exponent matrix having the same dimensions as the first exponent matrix.

Embodiments in the present disclosure have at least the following advantages and benefits.

First, embodiments in the present disclosure can provide useful techniques for providing significant gains (e.g., 0.0-0.5 dB over existing LDPC codes specified in the Wi-Fi standards) across all modulation schemes. For example, the block length (e.g., 7776 bits) of an QC-LDPC code according to some implementations is at least 4 times that of the longest code supported in 802.11n-802.11be standards (e.g., 1994 bits). This QC-LDPC code can provide within 2dB gain in 2x2 MIMO (multiple input multiple output) channels and the gains are consistent across all modulation schemes with or without beamforming.

Second, codes generated using systems and/or methods according to embodiments in the present disclosure can help in efficient encoding and decoding. For example, the system can perform decoding of data using message passing based algorithms so that a sub-structure can be used for parallel and/or concurrent decoding.

The following IEEE standard(s), including any draft versions of such standard(s), are hereby incorporated herein by reference in their entirety and are made part of the present disclosure for all purposes: WiFi Alliance standards and IEEE 802.11 standards including but not limited to IEEE 802.11a™, IEEE 802.11b™, IEEE 802.11g™, IEEE P802.11n™; IEEE P802.11ac™; and IEEE P802.11be™ through IEEE P802.11bn™ standards. Although this disclosure can reference aspects of these standard(s), the disclosure is in no way limited by these standard(s).

For purposes of reading the description of the various embodiments below, the following descriptions of the sections of the specification and their respective contents can be helpful:

- Section A describes a network environment and computing environment which can be useful for practicing embodiments described herein; and

- Section B describes embodiments of systems and methods for QC-LDPC code with 1/2 code rate.

A. COMPUTING AND NETWORK ENVIRONMENT

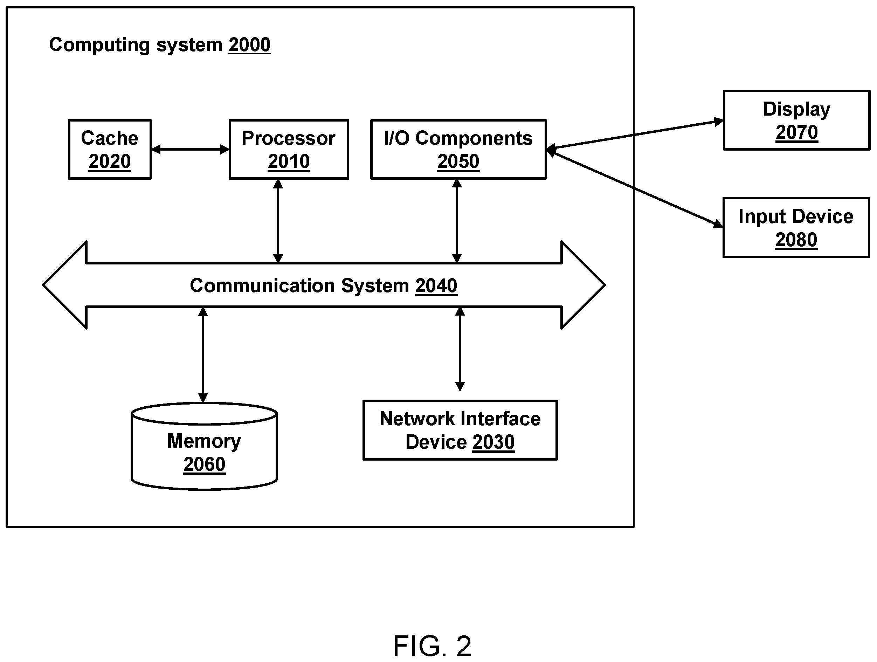

Referring to FIG. 1, illustrated is a diagram depicting an example communication environment 100 including communication systems (or communication apparatuses) 105, 108, according to one or more embodiments. In one embodiment, the communication system 105 includes a baseband circuitry 110 and a transmitter circuitry 120, and the communication system 108 includes a baseband circuitry 150 and a receiver circuitry 140. In one aspect, the communication system 105 is considered a transmitter communication system, and the communication system 108 is considered a receiver communication system. These components operate together to exchange data (e.g., messages or frames) through a wireless medium. These components are embodied as application specific integrated circuit (ASIC), field programmable gate array (FPGA), or any combination of these, in one or more embodiments. In some embodiments, the communication systems 105, 108 include more, fewer, or different components than shown in FIG. 1. For example, each of the communication systems 105, 108 includes transceiver circuitry to allow bi-directional communication between the communication systems 105, 108 or with other communication systems. In some embodiments, each of the communication systems 105, 108 may have configuration similar to that of a computing system 2000 as shown in FIG. 2.

The baseband circuitry 110 of the communication system 105 is a circuitry that generates the baseband data 115 for transmission. The baseband data 115 includes information data (e.g., signal(s)) at a baseband frequency for transmission. In one approach, the baseband circuitry 110 includes an encoder 130 that encodes the data, and generates or outputs parity bits. In one aspect, the baseband circuitry 110 (or encoder 130) obtains a generator matrix or a parity check matrix, or uses a previously produced generator matrix or a previously produced parity check matrix, and encodes the information data by applying the information data to the generator matrix or the parity check matrix to obtain a codeword. In some embodiments, the baseband circuitry 110 stores one or more generator matrices or one or more parity check matrices that conform to any IEEE 802.11 standard for WLAN communication. The baseband circuitry 110 retrieves the stored generator matrix or the stored parity check matrix in response to detecting information data to be transmitted, or in response to receiving an instruction to encode the information data. In one approach, the baseband circuitry 110 generates the parity bits according to a portion of the generator matrix or using the parity check matrix, and appends the parity bits to the information bits to form a codeword. The baseband circuitry 110 generates the baseband data 115 including the codeword for the communication system 108, and provides the baseband data 115 to the transmitter circuitry 120.

The transmitter circuitry 120 of the communication system 105 includes or corresponds to a circuitry that receives the baseband data 115 from the baseband circuitry 110 and transmits a wireless signal 125 according to the baseband data 115. In one configuration, the transmitter circuitry 120 is coupled between the baseband circuitry 110 and an antenna (not shown). In this configuration, the transmitter circuitry 120 up-converts the baseband data 115 from the baseband circuitry 110 onto a carrier signal to generate the wireless signal 125 at an RF frequency (e.g., 10 MHz to 60 GHz), and transmits the wireless signal 125 through the antenna.

The receiver circuitry 140 of the communication system 108 is a circuitry that receives the wireless signal 125 from the communication system 105 and obtains baseband data 145 from the received wireless signal 125. In one configuration, the receiver circuitry 140 is coupled between the baseband circuitry 150 and an antenna (not shown). In this configuration, the receiver circuitry 140 receives the wireless signal 125 though an antenna, and down-converts the wireless signal 125 at an RF frequency according to a carrier signal to obtain the baseband data 145 from the wireless signal 125. The receiver circuitry 140 then provides the baseband data 145 to the baseband circuitry 150.

The baseband circuitry 150 of the communication system 108 includes or corresponds to a circuitry that receives the baseband data 145 from the receiver circuitry 140 and obtains information data from the received baseband data 145. In one embodiment, the baseband circuitry 150 includes a decoder 160 that extracts information and parity bits from the baseband data 145. The decoder 160 decodes the baseband data 145 to obtain the information data generated by the baseband circuitry 110 of the communication system 105.

In some embodiments, each of the baseband circuitry 110 (including the encoder 130), the transmitter circuitry 120, the receiver circuitry 140, and the baseband circuitry 150 (including the decoder 160) may be as one or more processors, application specific integrated circuit (ASIC), field programmable gate array (FPGA), or any combination of them.

FIG. 2 is a schematic block diagram of a computing system, according to an embodiment. An illustrated example computing system 2000 includes one or more processors 2010 in direct or indirect communication, via a communication system 2040 (e.g., bus), with memory 2060, at least one network interface controller 2030 with network interface port for connection to a network (not shown), and other components, e.g., input/output ("I/O") components 2050. Generally, the processor(s) 2010 will execute instructions (or computer programs) received from memory. The processor(s) 2010 illustrated incorporate, or are connected to, cache memory 2020. In some instances, instructions are read from memory 2060 into cache memory 2020 and executed by the processor(s) 2010 from cache memory 2020. The computing system 2000 may not necessarily contain all of these components shown in FIG. 2, and may contain other components that are not shown in FIG. 2.

In more detail, the processor(s) 2010 may be any logic circuitry that processes instructions, e.g., instructions fetched from the memory 2060 or cache 2020. In many implementations, the processor(s) 2010 are microprocessor units or special purpose processors. The computing device 2050 may be based on any processor, or set of processors, capable of operating as described herein. The processor(s) 2010 may be single core or multi-core processor(s). The processor(s) 2010 may be multiple distinct processors.

The memory 2060 may be any device suitable for storing computer readable data. The memory 2060 may be a device with fixed storage or a device for reading removable storage media. Examples include all forms of volatile memory (e.g., RAM), non-volatile memory, media and memory devices, semiconductor memory devices (e.g., EPROM, EEPROM, SDRAM, and flash memory devices), magnetic disks, magneto optical disks, and optical discs (e.g., CD ROM, DVD-ROM, or Blu-Ray® discs). A computing system 2000 may have any number of memory devices 2060.

The cache memory 2020 is generally a form of computer memory placed in close proximity to the processor(s) 2010 for fast read times. In some implementations, the cache memory 2020 is part of, or on the same chip as, the processor(s) 2010. In some implementations, there are multiple levels of cache 2020, e.g., L2 and L3 cache layers.

The network interface controller 2030 manages data exchanges via the network interface (sometimes referred to as network interface ports). The network interface controller 2030 handles the physical and data link layers of the OSI model for network communication. In some implementations, some of the network interface controller's tasks are handled by one or more of the processor(s) 2010. In some implementations, the network interface controller 2030 is part of a processor 2010. In some implementations, the computing system 2000 has multiple network interfaces controlled by a single controller 2030. In some implementations, the computing system 2000 has multiple network interface controllers 2030. In some implementations, each network interface is a connection point for a physical network link (e.g., a cat-5 Ethernet link). In some implementations, the network interface controller 2030 supports wireless network connections and an interface port is a wireless (e.g., radio) receiver or transmitter (e.g., for any of the IEEE 802.11 protocols, near field communication "NFC", Bluetooth, ANT, or any other wireless protocol). In some implementations, the network interface controller 2030 implements one or more network protocols such as Ethernet. Generally, a computing device 2050 exchanges data with other computing devices via physical or wireless links through a network interface. The network interface may link directly to another device or to another device via an intermediary device, e.g., a network device such as a hub, a bridge, a switch, or a router, connecting the computing device 2000 to a data network such as the Internet.

The computing system 2000 may include, or provide interfaces for, one or more input or output ("I/O") devices. Input devices include, without limitation, keyboards, microphones, touch screens, foot pedals, sensors, MIDI devices, and pointing devices such as a mouse or trackball. Output devices include, without limitation, video displays, speakers, refreshable Braille terminal, lights, MIDI devices, and 2-D or 3-D printers.

Other components may include an I/O interface, external serial device ports, and any additional co-processors. For example, a computing system 2000 may include an interface (e.g., a universal serial bus (USB) interface) for connecting input devices, output devices, or additional memory devices (e.g., portable flash drive or external media drive). In some implementations, a computing device 2000 includes an additional device such as a co-processor, e.g., a math co-processor can assist the processor 2010 with high precision or complex calculations.

The components 2090 may be configured to connect with external media, a display 2070, an input device 2080 or any other components in the computing system 2000, or combinations thereof. The display 2070 may be a liquid crystal display (LCD), an organic light emitting diode (OLED) display, a flat panel display, a solid state display, a cathode ray tube (CRT) display, a projector, a printer or other now known or later developed display device for outputting determined information. The display 2070 may act as an interface for the user to see the functioning of the processor(s) 2010, or specifically as an interface with the software stored in the memory 2060.

The input device 2080 may be configured to allow a user to interact with any of the components of the computing system 2000. The input device 2080 may be a plurality pad, a keyboard, a cursor control device, such as a mouse, or a joystick. Also, the input device 2080 may be a remote control, touchscreen display (which may be a combination of the display 2070 and the input device 2080), or any other device operative to interact with the computing system 2000, such as any device operative to act as an interface between a user and the computing system 2000.

## B. SYSTEMS AND METHODS FOR QC-LDPC CODE WITH 1/2 CODE RATE

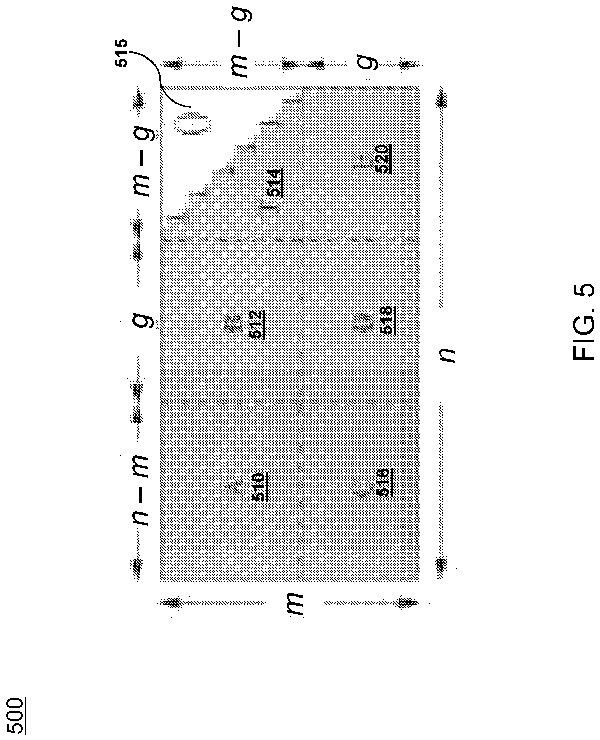

FIG. 3 is a diagram depicting an example exponent matrix (QC-LDPC exponent matrix) 300, according to one or more embodiments. Given a lifting size z, the exponent matrix 300 may have a size of $m/z \times n/z$. If $n=24z$ (e.g., $n= 7776$, $z=324$), then the size of $P=E(H)$ is $24(1-R) \times 24$ ($= n(1-R)/z \times n/z$). Elements of the exponent matrix may be integer values which correspond to cyclic shift values of identity matrix of size $z \times z$. A parity check matrix H (see FIG. 5) may be a sparse binary matrix that can be derived from an exponent matrix $P=E(H)$. The generator matrix G may have a size $n \times k$ in binary form (e.g., elements of the generator matrix G are binary values). Referring to FIG. 3, the exponent matrix $P=E(H)$ may have a structure including a plurality of sub-matrices (e.g., A 310, B 312, C 316, D 318, E 320, T 314).

FIG. 4 is a diagram 400 depicting example shifted identity matrices 409, 410, 411, 412, 413, 414, 415, 416 for generating a parity check matrix, according to one or more embodiments. A parity check matrix H may be generated from an exponent matrix P=E(H) (e.g., exponent matrix 300) or may be identified using a codebook. As shown in Equation 7, the exponent matrix P=E(H) may include (as elements) shift values d in the range 0<=d<z along with d=-1. See Equation For example, if z=7, the shift values d may include -1, 0, 1, 2, 3, 4, 5, 6 (see FIG. 4). The shift value d=0 may correspond (or map) to an identity matrix of size z x z, denoted by I(z) (e.g., matrix 410). The shift value d=-1 may correspond (or map) to a null matrix (all elements zero) of size z x z, denoted by 0*I(z) (e.g., matrix 409). Any other integer value d in [1,z-1] may correspond (or map) to a matrix cyclically right shifted from I(z) (e.g., matrices 411, 412, 413, 414, 415, 416). As shown in Equation 8, the parity check matrix H can be obtained from the exponent matrix P=E(H) by expanding the exponent matrix P such that each element of the exponent matrix P (as a shift value d) is replaced by a matrix corresponding to the shift value.

FIG. 5 is a diagram depicting an example parity check matrix 500, according to one or more embodiments. In some implementations, an encoder (e.g., encoder 130) can produce codewords using a generator matrix (e.g., using Equation 2). In some implementations, an encoder (e.g., encoder 130) can use the parity check matrix (rather than the generator matrix) to produce codewords from vectors of information bits. After a parity check matrix H is obtained (e.g., using a codebook), the parity check matrix H (e.g., parity check matrix 500) may have sub-matrices A 510, B 512, C 516, D 518, T 514, E 520. An upper area O 515 of the sub-matrix T 514 (e.g., white area in FIG. 5) may correspond to an area in which the matrix contains all zeroes, and the other areas (e.g., grey area in FIG. 5) may represent locations that can contain ones. The size of the parity check matrix 500 may be m x n where the size of the sub-matrix D 518 is g x g, and the size of the sub-matrix T is (m-g)x(m-g). In some implementations, given a vector s of information bits to be encoded, the encoder can obtain a codeword c using Equation 10, Equation 11, Equation 12 and Equation 13.

In some implementations, a codebook for R=1/2 LDPC code of blocklength= 7776 bits can provide high performance error correction and/or provide up to 0.0-0.5 dB over existing LDPC codes specified in the Wi-Fi standards. In some implementations, a collection of LDPC codes with a block length of 7776 bits (4x1944), supporting all the code rates in a Wi-Fi standard (e.g., 802.11be). The code (e.g., R=1/2 LDPC code of blocklength= 7776 bits) can be directly used in an existing modulation of 64-QAM in the IEEE 802.11be and potentially in combination with more combinations of QAM sizes in the IEEE 802.bn.

In some implementations, a codebook for R=1/2 LDPC code of blocklength= 7776 bits can be directly used in an existing modulation as in existing modulation scheme like binary phase-shift keying (BPSK), quadrature phase-shift keying (BPSK), 16-QAM, 64-QAM, 256-QAM, 1024-QAM, and 4096-QAM, as seen in standards such as IEEE 802.11be or IEEE 802.11bn. Moreover, a codebook for R=1/2 LDPC code of blocklength= 7776 bits can have the potential to be employed in conjunction with one or more combinations of QAM sizes, whether similar or different, across OFDMA resource units (RU), distributed RU (DRU), punctured RUs (MRU), within a single stream and or across multiple spatial streams, as provisioned in MIMO configurations.

The collection of LDPC codes with a block length of 7776 bits (4x1944) can deliver considerable performance improvements in various communication scenarios in ultra high reliability (UHR), while maintaining manageable complexity. Performance comparisons are conducted between these codes and LDPC codes specified in the IEEE 802.11be standards, as well as recently proposed codes with a block length of 4x1944. Results of the performance comparisons show demonstrable gains across the board (e.g., channels, PHY bandwidth, MIMO, modulation coding scheme (MCS), Transmit Beamforming). For example, LDPC codes with a block length of 4x1944=7776 bits can provide additional 0.0-0.5 dB gain, depending on channel conditions.

The longest LDPC codes specified in 802.11be standards have block length=1944 bits. Performance wise, the LDPC codes specified in 802.11be standards are about 2.7dB away from the optimum random codes (e.g., bit-interleaved coded modulation (BICM)-additive white Gaussian noise (AWGN)-QAM (Quadrature Amplitude Modulation) R=1/2 limits). Longer blocklength random codes (e.g., the Shannon limit deals with the asymptotic case when the blocklength grows unboundedly large) can lead to enhanced coding gains, in accordance with the finite-length scaling laws. Deterministic codes, which are suboptimal, can exhibit scaling gains that are significantly larger than those of optimal random codes. For example, in AWGN a doubling effect is known to be true.

In some implementations, LDPC codes with blocklength=4x1944=7776 bits (which double the size of maximum supported blocklength in the present 802.11be standards). In some implementations, LDPC codes with blocklength=7776 bits can support all the existing code rates (e.g., R=1/2, 2/3, 3/4 and 5/6). In some implementations, LDPC codes with blocklength=7776 bits can keep the structure of the 802.11be code, QC-LDPC specifically, unchanged, except for the matrix size expansion. This adaptation can facilitate the reutilization of existing implementations and to empower concurrent encoding and decoding functionalities.

FIG. 6 is a diagram depicting an example exponent matrix (QC-LDPC exponent matrix) 600, according to one or more embodiments. Given a lifting size z, the exponent matrix 600 may have a size of m/z x n/z. If n=48z (e.g., n=7776, z=324/2=162=2*81), then the size of P=E(H) matrix for n=7776 is 48(1-R) x 48 (= n(1-R)/z x n/z)=8x48. Elements of the exponent matrix may be integer values which correspond to cyclic shift values of identity matrix of size z x z. A parity check matrix H may be a sparse binary matrix that can be derived from an exponent matrix P=E(H). The generator matrix G may have a size n x k in binary form (e.g., elements of the generator matrix G are binary values). Referring to FIG. 6, the exponent matrix P=E(H) may have a structure including a plurality of sub-matrices (e.g., Á 610, B́ 612, Ć 616, D́ 618, É 620, T́ 614).

FIG. 7A and FIG. 7B are diagrams depicting an example exponent matrix 700 and an example binary parity check matrix 750, according to one or more embodiments. The exponent matrix 700 and the binary parity check matrix 750 correspond to a QC-LDPC codebook of blocklength n = 7776 bits, rate R= 1/2, and information length k = 1/2*7776 =3888 bits. The parity check matrix (H) 750 has size = (1-R)*n x n = 1296 x 7776. The exponent matrix (E(H)) 700 is equivalent to the parity check matrix (H) 750. The exponent matrix 700 has size 24*(1-R) x 24 and contains cyclic shift values such that each of the entries gets mapped to circulant matrix of size Z=324 (see FIG. 3). Elements of the exponent matrix 700 are integers between -1 and Z-1 (Z=324).

FIG. 8A to FIG. 8C are diagrams depicting an example exponent matrix 800, an example binary matrix λ 820 (also referred to as "compact matrix" or "λ matrix"), and an example binary parity check matrix 840, according to one or more embodiments. Given a first QC-LDPC code of (n=7776, k=3888) corresponding to the exponent matrix 700 and the parity check matrix 750 (referred to as "E1(H)" and "H1" respectively), the system can identify, find, obtain, or calculate a second QC-LDPC code of (n=7776, k=3888) corresponding to the exponent matrix 800 and the parity check matrix 840 (referred to as "E2(H)" and "H2" respectively). The exponent matrix E2(H) 800 can have size 48*(1-R) x 48 and contains cyclic shift values such that each of the entries gets mapped to circulant matrix of size Z=324/2= 162=2*81 (see FIG. 6). The parity check matrix H2 840 can be different from the parity check matrix H1 750, but both the overall graph structure and performance can be similar to each other. Given the first exponent matrix E1(H) 700, the system can apply the mapping using Equation 17 and Equation 18 to E1(H) to obtain the second exponent matrix E2(H) 800 and the compact matrix λ 820. The system can define, generate, or create the parity check matrix H2 840 which has size = (1-R)*n x n = 1296 x 7776, based on E2(H) using Equations 7-9.

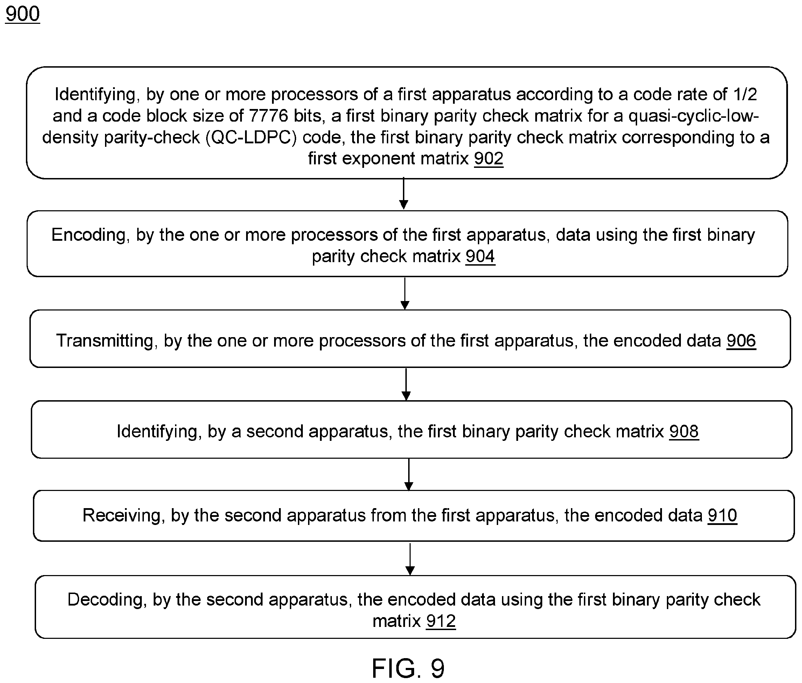

FIG. 9 is a flow diagram showing a process 900 for encoding data and/or decoding data using an LDPC code, in accordance with an embodiment. In some embodiments, the process 900 is performed by one or more processors of a first apparatus (e.g. encoder 130 or processor 2010 of communication system 105) or by one or more processors of a second apparatus (e.g., decoder 160 or processor 2010 of communication system 108). In other embodiments, the process 900 is performed by other entities (e.g., a computing system other than the communication system 105 or 108). In some embodiments, the process 900 includes more, fewer, or different steps than shown in FIG. 9.

At step 902, the first apparatus may identify, according to a code rate of 1/2 and a code block size of 7776 bits, a first binary parity check matrix (e.g., matrix 750 or matrix 840) for a quasi-cyclic-low-density parity-check (QC-LDPC) code, the first binary parity check matrix corresponding to a first exponent matrix (e.g., matrix 700 or matrix 800). At step 904, the first apparatus may encode data using the first binary parity check matrix. At step 906, the first apparatus may transmit the encoded data via a transmitter (e.g., transmitter circuitry 120).

In some implementations, the first exponent matrix may have 1152 values (e.g., matrix 800). The one or more processors may be further configured to generate the first exponent matrix based at least on a second exponent matrix having 288 values (e.g., matrix 700). In generating the first exponent matrix, the one or more processors may be configured to replace each value of the second exponent matrix with a (2x2) matrix (e.g., using Equation 17). In some implementations, the first exponent matrix may be generated based at least on the second exponent matrix (e.g., matrix 700) according to a binary matrix. The binary matrix may include the following set of values: [1 1 1 1 1 1 1 0 1 0 1 0 0 1 1 1 1 1 1 1 1 0 1 1 1 0 1 1 1 0 1 1 1 1 0 0 1 1 1 1 1 1 1 1 1 0 1 1 1 1 0 1 1 0 1 1 1 1 1 0 0 1 1 1 1 1 1 1 1 0 0 1 1 1 1 1 0 0 1111110011111111111101111 1111111100111111011111011111111110011111101111101111 111111100111111011111011110111110011111111101111111 111111001110111111011111 111110010011011111111111111110011111100110011111 1 1 1 1 1 1 0].

In some implementations, the first exponent matrix (e.g., matrix 800) may include the following set of values: [-1 115 -1 -1 -1 -1 -1 -1 101 -1 -1 -1 22 -1 -1 100 -1 -1 -1 159 - 1 -1 -1 2 -1 0 -1 -1 -1 -1 -1 -1 -1 -1 -1 -1 -1 -1 -1 -1 -1 -1 -1 -1 -1 -1 115 -1 -1 -1 -1 -1 -1 101 -1 -1 -1 22 -1 -1 -1 100 -1 -1 -1 159 -1 -1 -1 2 -1 0 -1 -1 -1 -1 -1 -1 -1 -1 -1 -1 -1 -1 -1 -1 -1 -1 -1 -1 7 -1 -1 -1 -1 57 -1 -1 1 -1 -1 -1 -1 -1 -1 110 -1 -1 115 -1 -1 -1 -1 -1 -1 0 -1 0 -1 -1 -1 -1 -1 -1 -1 -1 -1 -1 -1 -1 -1 -1 -1 17 -1 -1 157 -1 -1 -1 -1 1 -1 -1 -1 -1 -1 -1 1110 15 -1 -1 -1 -1 -1 -1 -1 0 -1 0 -1 -1 -1 -1 -1 -1 -1 -1 -1 -1 -1 -1 -1 -1 -1 60 -1 -1 -1 -1 -1 -1 -1 -1 49 74 -1 -1 -1 -1 -1 1 112 -1 -1 1 29 -1 -1 -1 -1 -1 -1 -1 0 -1 0 -1 -1 -1 -1 -1 -1 -1 -1 -1 -1 -1 -1 -1 -1 -1 60 -1 -1 -1 -1 -1 -1 -1 1 49 -1 -1 1 74 -1 -1 -1 -1 -1 1 112 29 -1 -1 -1 -1 -1 -1 -1 -1 -1 -1 0 -1 0 -1 -1 -1 -1 -1 -1 -1 -1 -1 -1 -1 -1 -1 -1 124 -1 106 -1 -1 -1 -1 -1 -1 107 -1 -1 -1 -1 6 -1 70 -1 -1 -1 -1 -1 -1 -1 -1 -1 -1 -1 -1 -1 0 -1 0 -1 -1 -1 -1 -1 -1 -1 -1 -1 -1 -1 -1 -1 -1 124 -1 106 -1 -1 -1 -1 1 107 -1 -1 -1 -1 6 -1 70 -1 -1 -1 -1 -1 -1 -1 -1 -1 -1 -1 -1 -1 0 -1 0 -1 -1 -1 -1 -1 -1 -1 -1 -1 -1 -1 -1 81 -1 -1 -1 -1 1 40 -1 -1 132 -1 -1 -1 -1 -1 1 45 -1 57 -1 -1 -1 -1 -1 -1 -1 -1 -1 -1 -1 -1 -1 0 -1 0 -1 -1 -1 -1 -1 -1 -1 -1 -1 -1 -1 -1 1 81 - 1 -1 -1 -1 -1 1 40 132 -1 -1 -1 -1 -1 1 45 -1 57 -1 -1 -1 -1 -1 -1 -1 -1 -1 -1 -1 -1 -1 0 -1 0 -1 -1 -1 -1 -1 -1 -1 -1 -1 -1 -1 -1 0 -1 -1 -1 -1 -1 -1 -1 16 -1 -1 84 -1 -1 -1 -1 101 -1 -1 -1 -1 -1 16 -1 -1 -1 -1 -1 -1 -1 -1 -1 -1 0 -1 0 -1 -1 -1 -1 -1 -1 -1 -1 -1 -1 -1 0 -1 -1 -1 -1 -1 16 -1 -1 -1 84 -1 -1 101 -1 -1 -1 -1 16 -1 -1 -1 -1 -1 -1 -1 -1 -1 -1 -1 -1 -1 0 -1 0 -1 -1 -1 -1 -1 -1 -1 -1 -1 1138 158 -1 -1 158 -1 -1 -1 -1 -1 1113 -1 -1 -1 -1 104 -1 -1 -1 -1 -1 -1 0 -1 -1 -1 -1 -1 -1 -1 -1 -1 -1 -1 -1 0 -1 0 -1 -1 -1 -1 -1 -1 -1 1138 -1 -1 1158 158 -1 -1 -1 -1 -1 -1 -1 113 -1 -1 104 -1 -1 -1 -1 -1 -1 -1 0 -1 -1 -1 -1 -1 -1 -1 -1 -1 -1 0 -1 0 -1 -1 -1 -1 -1 -1 -1 1130 -1 -1 -1 -1 -1 -1 176 114 -1 -1 -1 -1 -1 -1 1144 -1 -1 -1 1 54 -1 -1 -1 -1 -1 -1 -1 -1 -1 -1 -1 -1 -1 -1 -1 -1 -1 0 -1 0 -1 -1 -1 -1 -1 -1 -1 -1 1130 -1 -1 -1 -1 -1 -1 176 -1 -1 1 114 -1 -1 -1 -1 144 - 1 -1 -1 54 -1 -1 -1 -1 -1 -1 -1 -1 -1 -1 -1 -1 -1 -1 -1 -1 -1 -1 -1 0 -1 0 -1 -1 -1 -1 -1 -1 -1 129 -1 -1 -1 -1 -1 -1 -1 28 -1 -1 104 -1
-1 -1 -1 -1 61 -1 -1 -1 -1 -1 65 -1 -1 -1 -1 -1 -1 -1 -1 -1 -1 -1 -1 -1 -1 -1 -1 0 -1 0 -1 -1 -1 -1 -1 129 -1 -1 -1 -1 -1 -1 -1 28 104 -1 -1 -1
-1 -1 61 -1 -1 -1 -1 -1 65 -1 -1 -1 -1 -1 -1 -1 -1 -1 -1 -1 -1 -1 -1 -1 -1 -1 0 -1 0 -1 -1 -1 -1 -1 91 -1 -1 -1 -1 141 -1 0 -1 -1 -1 -1 -1 -1
-1 154 18 -1 -1 -1 -1 -1 -1 -1 -1 -1 -1 -1 -1 -1 -1 -1 -1 -1 -1 -1 -1 -1 -1 -1 0 -1 0 -1 -1 -1 -1 -1 91 -1 -1 141 -1 0 -1 -1 -1 -1 -1 -1 154
-1 -1 18 -1 -1 -1 -1 -1 -1 -1 -1 -1 -1 -1 -1 -1 -1 -1 -1 -1 -1 -1 -1 -1 -1 -1 0 -1 0 -1 -1 14 -1 112 -1 -1 -1 -1 115 70 -1 -1 -1 -1 -1 -1 -1 -1 -1
-1 -1 124 -1 -1 -1 -1 -1 -1 -1 -1 -1 -1 -1 -1 -1 -1 -1 -1 -1 -1 -1 -1 -1 -1 -1 0 -1 0 -1 -1 14 -1 112 -1 -1 115 -1 -1 170 -1 -1 -1 -1 -1 -1 -1 -1 -1 124
-1 -1 -1 -1 -1 -1 -1 -1 -1 -1 -1 -1 -1 -1 -1 -1 -1 -1 -1 -1 -1 -1 -1 -1 -1 -1 0 -1 0 -1 49 -1 -1 123 -1 -1 121 -1 -1 -1 -1 55 -1 102 -1 -1 -1 -1
-1 32 -1 2 -1 -1 -1 -1 -1 -1 -1 -1 -1 -1 -1 -1 -1 -1 -1 -1 -1 -1 -1 -1 -1 -1 0 -1 49 -1 -1 123 -1 -1 121 - 1 -1 -1 -1 -1 55 -1 102 -1 -1 -1
-1 -1 32 -12 -1 -1 -1 -1 -1 -1 -1 -1 -1 -1 -1 -1 -1 -1 -1 -1 -1 - 1 -1 -1 -1 0].

In some implementations, the first exponent matrix (e.g., matrix 700) may include the following set of values: [231
-1 -1 -1 203 -1 45 -1 200 -1 318 -1 4 0 -1 -1 -1 -1 -1 -1 -1 - 1 -1 114 -1 115 -12 -1 -1 -1 220 31 -1 -1 -1 0 0 -1 -1 -1 -1 -1 -1 -1 -1 -1
120 -1 -1 -1 99 148 -1 -1 224 59 -1 -1 -1 -1 0 0 -1 -1 -1 -1 -1 -1 -1 248 212 -1 -1 215 -1 -1 112 140 -1 -1 -1 -1 -1 0 0 -1 -1 -1 -1 -1
-1 -1 163 -1 -1 80 265 -1 -1 91 115 -1 -1 -1 -1 -1 -1 -1 0 0 -1 -1 -1 -1 -1 -1 0 -1 -1 -1 33 -1 168 -1 203 -1 -1 33 -1 -1 -1 -1 -1 0 0 -1 -1 -1
-1 -1 277 316 317 -1 -1 -1 226 -1 209 -1 -1 0 -1 -1 -1 -1 -1 0 0 -1 -1 -1 -1 261 -1 -1 -1 153 228 -1 -1 289 -1 109 -1 -1 -1 -1 -1 -1 -1 -1
-1 0 0 -1 -1 -1 259 -1 1 -1 1 56 209 -1 -1 123 -1 -1 131 -1 -1 -1 -1 -1 -1 -1 -1 -1 0 0 -1 -1 -1 182 -1 283 1 -1 -1 -1 309 36 -1 -1 -1 -1 -1 -1 -1 -1
-1 -1 -1 -1 -1 0 0 -1 -1 18 224 -1 231 140 -1 -1 -1 -1 -1 149 -1 -1 -1 -1 -1 -1 -1 -1 -1 -1 -1 0 099 -1 247 -1 243 -1 -1 1 110 204 -1 -1 1 64 4 -1 -1 -1
-1 -1 -1 -1 -1 -1 -1 0].

In some implementations, the one or more processors may be further configured to generate the first exponent matrix by re-arranging a third exponent matrix having the same dimensions as the first exponent matrix (e.g., 12x24). The third exponent matrix may be re-arranged such that a position of one or more elements or one or more submatrices is changed and the re-arranged third exponent matrix contains the same elements as the first exponent matrix.

In some implementations, the first exponent matrix may have dimensions of m x n where each of m and n is a positive integer. The one or more processors may be further configured to generate the first exponent matrix by performing the following matrix multiplication: A*E(H)*B (e.g., using Equation 19) where A is a permutation matrix having dimensions of m x m, B is a permutation matrix having dimensions n x n, and E(H) is a fourth exponent matrix having the same dimensions as the first exponent matrix.

At step 908, the second apparatus (e.g., communication system 105) may identify, according to the code rate of 1/2 and the code block size of 7776 bits, the first binary parity check matrix (e.g., matrix 750, matrix 840) for the quasi-cyclic-low-density parity-check (QC-LDPC) code, the first binary parity check matrix corresponding to the first exponent matrix (e.g., matrix 700, matrix 800). At step 910, the second apparatus may to receive encoded data from the first apparatus (e.g., communication system 108) via a receiver (e.g., receiver circuitry 140). At step 912, the second apparatus may decode the received encoded data using the first binary parity check matrix.

References to "or" may be construed as inclusive so that any terms described using "or" may indicate any of a single, more than one, and all of the described terms. References to at least one of a conjunctive list of terms may be construed as an inclusive OR to indicate any of a single, more than one, and all of the described terms. For example, a reference to "at least one of 'A' and 'B'" can include only 'A', only 'B', as well as both 'A' and 'B'. Such references used in conjunction with "comprising" or other open terminology can include additional items.

It should be noted that certain passages of this disclosure can reference terms such as "first" and "second" in connection with subsets of transmit spatial streams, sounding frames, response, and devices, for purposes of identifying or differentiating one from another or from others. These terms are not intended to merely relate entities (e.g., a first device and a second device) temporally or according to a sequence, although in some cases, these entities can include such a relationship. Nor do these terms limit the number of possible entities (e.g., STAs, APs, beamformers and/or beamformees) that can operate within a system or environment. It should be understood that the systems described above can provide multiple ones of any or each of those components and these components can be provided on either a standalone machine or, in some embodiments, on multiple machines in a distributed system. Further still, bit field positions can be changed and multibit words can be used. In addition, the systems and methods described above can be provided as one or more computer-readable programs or executable instructions embodied on or in one or more articles of manufacture, e.g., a floppy disk, a hard disk, a CD-ROM, a flash memory card, a PROM, a RAM, a ROM, or a magnetic tape. The programs can be implemented in any programming language, such as LISP, PERL, C, C++, C#, or in any byte code language such as JAVA. The software programs or executable instructions can be stored on or in one or more articles of manufacture as object code.

While the foregoing written description of the methods and systems enables one of ordinary skill to make and use embodiments thereof, those of ordinary skill will understand and appreciate the existence of variations, combinations, and equivalents of the specific embodiment, method, and examples herein. The present methods and systems should therefore not be limited by the above described embodiments, methods, and examples, but by all embodiments and methods within the scope and spirit of the disclosure.

**Claims**

1. An apparatus (105) comprising:

   a transmitter (120) and one or more processors (2010), wherein
   the one or more processors (2010) are configured to:

   identify, according to a code rate of 1/2 and a code block size of 7776 bits, a first binary parity check matrix for a quasi-cyclic-low-density parity-check, QC-LDPC, code, the first binary parity check matrix corresponding to a first exponent matrix; and
   encode data using the first binary parity check matrix; and

   the transmitter (120) is configured to transmit the encoded data.

2. The apparatus (105) of claim 1, wherein

   the first exponent matrix has 1152 values, and
   the one or more processors (2010) are further configured to:
   generate the first exponent matrix based at least on a second exponent matrix having 288 values.

3. The apparatus (105) of claim 2, wherein in generating the first exponent matrix, the one or more processors (2010) are configured to:
   replace each value of the second exponent matrix with a (2x2) matrix.

4. The apparatus (105) of claim 2 or 3, wherein the first exponent matrix is generated based at least on a second exponent matrix according to a binary matrix.

5. The method of claim 4, wherein
   the binary matrix comprises the following set of values:

   [1 1 1 1 1 1 1 0 1 0 1 0 0 1 1 1 1 1 1 1 1 1 1 0 1 1 1 0 1 1 1 0 1 1 1 1 0 0 1 1 1 1 1 1 1 1 0 1 1 1 1 0 1 1 0 1 1 1 1 1 0 0 1 1 1 1 1 1 1 1 0 0 1 1 1 1 1 0 0 1 1 1 1 1 1 0 0 1 1 1 1 1 1 1 1 0 1 1 1 1 1 1 1 1 1 1 1 1 1 0 0 1 1 1 1 1 1 0 1 1 1 1 1 0 1 1 1 1 1 1 1 1 1 0 0 1 1 1 1 1 0 1 1 1 1 0 1 1 1 1 1 0 0 1 1 1 1 1 1 1 1 0 1 1 1 1 1 1 1 1 1 1 1 1 1 0 0 1 1 1 1 1 1 0 1 1 1 1 1 1 1 1 1 1 1 1 0 0 1 1 0 1 1 1 1 1 1 0 1 1 1 1 1 1 1 1 1 1 0 0 1 0 0 1 1 0 1 1 1 1 1 1 1 1 1 1 1 1 1 0 0 1 1 1 1 1 1 0 0 1 1 0 0 1 1 1 1 1 1 1 1 1 0].

6. The apparatus (105) of any of claims 1 to 5, comprising at least one of the following features:
   wherein
   the first exponent matrix comprises the following set of values:

[-1 115 -1 -1 -1 -1 -1 -1 -1 101 -1 -1 -1 22 -1 -1 100 -1 -1 -1 159 -1 -1 -1 2 -1 0 -1 -1 -1 -1 -1 -1 -1 -1 -1 -1 -1 -1 -1 -1 -1 -1 -1 -1 -1 -1 -1 -1 -1 115 -1 -1 -1 -1 -1 -1 -1 101 -1 -1 -1 22 -1 -1 -1 -1 100 -1 -1 -1 159 -1 -1 -1 2 -1 0 -1 -1 -1 -1 -1 -1 -1 -1 -1 -1 -1 -1 -1 -1 -1 -1 -1 -1 -1 -1 7 -1 -1 -1 -1 57 -1 -1 1 -1 -1 -1 -1 -1 -1 110 -1 -1 15 -1 -1 -1 -1 -1 -1 0 -1 0 -1 -1 -1 -1 -1 -1 -1 -1 -1 -1 -1 -1 -1 -1 -1 -1 -1 -1 7 -1 -1 57 -1 -1 -1 -1 1 -1 -1 -1 -1 -1 -1 -1 110 15 -1 -1 -1 -1 -1 -1 -1 -1 0 -1 0 -1 -1 -1 -1 -1 -1 -1 -1 -1 -1 -1 -1 -1 -1 -1 -1 60 -1 -1 -1 -1 -1 -1 -1 49 74 -1 -1 -1 -1 -1 112 -1 -1 29 -1 -1 -1 -1 -1 -1 -1 -1 0 -1 0 -1 -1 -1 -1 -1 -1 -1 -1 -1 -1 -1 -1 -1 -1 -1 -1 -1 60 -1 -1 -1 -1 -1 -1 49 -1 -1 74 -1 -1 -1 -1 -1 112 29 -1 -1 -1 -1 -1 -1 -1 -1 -1 0 -1 0 -1 -1 -1 -1 -1 -1 -1 -1 -1 -1 -1 -1 -1 -1 -1 124 -1 106 -1 -1 -1 -1 -1 -1 107 -1 -1 -1 -1 6 -1 70 -1 -1 -1 -1 -1 -1 -1 -1 -1 -1 -1 -1 -1 0 -1 0 -1 -1 -1 -1 -1 -1 -1 -1 -1 -1 -1 -1 -1 -1 -1 124 -1 106 -1 -1 -1 -1 107 -1 -1 -1 -1 -1 -1 6 -1 70 -1 -1 -1 -1 -1 -1 -1 -1 -1 -1 -1 -1 -1 0 -1 0 -1 -1 -1 -1 -1 -1 -1 -1 -1 -1 -1 -1 -1 81 -1 -1 -1 -1 40 -1 -1 132 -1 -1 -1 -1 45 -1 57 -1 -1 -1 -1 -1 -1 -1 -1 -1 -1 -1 -1 -1 0 -1 0 -1 -1 -1 -1 -1 -1 -1 -1 -1 -1 -1 -1 -1 81 -1 -1 -1 -1 -1 -1 40 132 -1 -1 -1 -1 -1 45 -1 57 -1 -1 -1 -1 -1 -1 -1 -1 -1 -1 -1 -1 -1 -1 -1 -1 0 -1 0 -1 -1 -1 -1 -1 -1 -1 -1 -1 -1 -1 -1 0 -1 -1 -1 -1 -1 -1 -1 16 -1 -1 84 -1 -1 -1 -1 101 -1 -1 -1 -1 -1 16 -1 -1 -1 -1 -1 -1 -1 -1 -1 -1 0 -1 0 -1 -1 -1 -1 -1 -1 -1 -1 -1 -1 -1 -1 -1 0 -1 -1 -1 -1 -1 -1 16 -1 -1 -1 -1 84 -1 -1 101 -1 -1 -1 -1 -1 16 -1 -1 -1 -1 -1 -1 -1 -1 -1 -1 -1 -1 -1 0 -1 0 -1 -1 -1 -1 -1 -1 -1 -1 -1 -1 138 158 -1 -1 158 -1 -1 -1 -1 -1 -1 113 -1 -1 -1 -1 104 -1 -1 -1 -1 -1 -1 0 -1 -1 -1 -1 -1 -1 -1 -1 -1 -1 -1 0 -1 0 -1 -1 -1 -1 -1 -1 -1 -1 -1 138 -1 -1 158 158 -1 -1 -1 -1 -1 -1 -1 -1 113 -1 -1 104 -1 -1 -1 -1 -1 -1 -1 -1 0 -1 -1 -1 -1 -1 -1 -1 -1 -1 -1 -1 0 -1 0 -1 -1 -1 -1 -1 -1 -1 -1 -1 130 -1 -1 -1 -1 -1 -1 -1 76 114 -1 -1 -1 -1 -1 -1 144 -1 -1 -1 54 -1 -1 -1 -1 -1 -1 -1 -1 -1 -1 -1 -1 -1 -1 -1 -1 -1 0 -1 0 -1 -1 -1 -1 -1 -1 -1 130 -1 -1 -1 -1 -1 -1 -1 76 -1 -1 114 -1 -1 -1 -1 144 -1 -1 -1 54 -1 -1 -1 -1 -1 -1 -1 -1 -1 -1 -1 -1 -1 -1 -1 -1 -1 -1 0 -1 0 -1 -1 -1 -1 -1 -1 -1 129 -1 -1 -1 -1 -1 -1 28 -1 -1 104 -1 -1 -1 -1 -1 61 -1 -1 -1 -1 -1 65 -1 -1 -1 -1 -1 -1 -1 -1 -1 -1 -1 -1 -1 -1 -1 -1 0 -1 0 -1 -1 -1 -1 -1 129 -1 -1 -1 -1 -1 -1 -1 28 104 -1 -1 -1 -1 -1 61 -1 -1 -1 -1 65 -1 -1 -1 -1 -1 -1 -1 -1 -1 -1 -1 -1 -1 -1 -1 0 -1 0 -1 -1 -1 -1 -1 -1 91 -1 -1 -1 -1 141 -1 0 -1 -1 -1 -1 -1 -1 -1 154 18 -1 -1 -1 -1 -1 -1 -1 -1 -1 -1 -1 -1 -1 -1 -1 -1 -1 -1 -1 -1 -1 -1 0 -1 0 -1 -1 -1 -1 -1 -1 91 -1 -1 141 -1 0 -1 -1 -1 -1 -1 -1 -1 154 -1 -1 18 -1 -1 -1 -1 -1 -1 -1 -1 -1 -1 -1 -1 -1 -1 -1 -1 -1 -1 -1 -1 -1 0 -1 0 -1 -1 4 -1 112 -1 -1 -1 -1 115 70 -1 -1 -1 -1 -1 -1 -1 -1 -1 -1 -1 24 -1 -1 -1 -1 -1 -1 -1 -1 -1 -1 -1 -1 -1 -1 -1 -1 -1 -1 -1 -1 -1 -1 0 -1 0 -1 -1 4 -1 112 -1 -1 115 -1 -1 70 -1 -1 -1 -1 -1 -1 -1 -1 -1 -1 24 -1 -1 -1 -1 -1 -1 -1 -1 -1 -1 -1 -1 -1 -1 -1 -1 -1 -1 -1 -1 -1 -1 -1 -1 -1 0 -1 0 -1 49 -1 -1 -1 123 -1 -1 -1 121 -1 -1 -1 -1 55 -1 102 -1 -1 -1 -1 -1 32 -1 2 -1 -1 -1 -1 -1 -1 -1 -1 -1 -1 -1 -1 -1 -1 -1 -1 -1 -1 -1 -1 -1 0 -1 49 -1 -1 -1 123 -1 -1 -1 121 -1 -1 -1 -1 -1 55 -1 102 -1 -1 -1 -1 -1 32 -1 2 -1 -1 -1 -1 -1 -1 -1 -1 -1 -1 -1 -1 -1 -1 -1 -1 -1 -1 -1 -1 0];

wherein
the first exponent matrix comprises the following set of values:

[231 -1 -1 -1 203 -1 45 -1 200 -1 318 -1 4 0 -1 -1 -1 -1 -1 -1 -1 -1 -1 -1 14 -1 115 -1 2 -1 -1 -1 220 31 -1 -1 -1 0 0 -1 -1 -1 -1 -1 -1 -1 -1 -1 120 -1 -1 -1 99 148 -1 -1 224 59 -1 -1 -1 -1 0 0 -1 -1 -1 -1 -1 -1 -1 248 212 -1 -1 215 -1 -1 12 140 -1 -1 -1 -1 -1 -1 0 0 -1 -1 -1 -1 -1 -1 163 -1 -1 80 265 -1 -1 91 115 -1 -1 -1 -1 -1 -1 -1 0 0 -1 -1 -1 -1 -1 -1 0 -1 -1 -1 33 -1 168 -1 203 -1 -1 33 -1 -1 -1 -1 -1 0 0 -1 -1 -1 -1 -1 277 316 317 -1 -1 -1 226 -1 209 -1 -1 -1 0 -1 -1 -1 -1 -1 -1 0 0 -1 -1 -1 -1 261 -1 -1 -1 153 228 -1 -1 289 -1 109 -1 -1 -1 -1 -1 -1 -1 -1 0 0 -1 -1 -1 259 -1 1 -1 56 209 -1 -1 123 -1 -1 131 -1 -1 -1 -1 -1 -1 -1 -1 0 0 -1 -1 -1 182 -1 283 1 -1 -1 -1 309 36 -1 -1 -1 -1 -1 -1 -1 -1 -1 -1 -1 0 0 -1 8 224 -1 231 140 -1 -1 -1 -1 -1 49 -1 -1 -1 -1 -1 -1 -1 -1 -1 -1 -1 0 0 99 -1 247 -1 243 -1 -1 110 204 -1 -1 64 4 -1 -1 -1 -1 -1 -1 -1 -1 -1 0];

wherein the one or more processors (2010) are further configured to:

    generate the first exponent matrix by re-arranging a third exponent matrix having the same dimensions as the first exponent matrix,
    wherein the third exponent matrix is re-arranged such that a position of one or more elements or one or more submatrices is changed and the re-arranged third exponent matrix contains the same elements as the first exponent matrix;

wherein

    the first exponent matrix has dimensions of m x n where each of m and n is a positive integer, and
    the one or more processors (2010) are further configured to:
    generate the first exponent matrix by performing the following matrix multiplication: A*E(H)*B,
    wherein A is a permutation matrix having dimensions of m x m, B is a permutation matrix having dimensions n x n, and E(H) is a fourth exponent matrix having the same dimensions as the first exponent matrix.

7.  A method, comprising:

    identifying, by one or more processors (2010) of a first device according to a code rate of 1/2 and a code block size of 7776 bits, a first binary parity check matrix for a quasi-cyclic-low-density parity-check, QC-LDPC, code, the first binary parity check matrix corresponding to a first exponent matrix;
    encoding, by the one or more processors (2010) of the first device, data using the first binary parity check matrix; and
    transmitting, by the one or more processors (2010) of the first device, the encoded data.

8.  The method of claim 7, wherein

    the first exponent matrix has 1152 values, and

the method further comprises:
generating the first exponent matrix based at least on a second exponent matrix having 288 values.

9. The method of claim 8, wherein generating the first exponent matrix comprises:
replacing each value of the second exponent matrix with a (2x2) matrix.

10. The method of claim 8 or 9, wherein the first exponent matrix is generated based at least on a second exponent matrix according to a binary matrix.

11. The method of claim 10, wherein
the binary matrix comprises the following set of values:

[1 1 1 1 1 1 1 0 1 0 1 0 0 1 1 1 1 1 1 1 1 1 0 1 1 1 0 1 1 1 0 1 1 1 1 0 0 1 1 1 1 1 1 1 1 1 0 1 1 1 1 0 1 1 0 1 1 1 1 1 0 0 1 1 1 1 1 1 1 0 0 1 1 1 1 1 0 0 1 1 1 1 1 0 0 1 1 1 1 1 1 1 1 1 0

1 1 1 1 1 1 1 1 1 1 1 1 0 0 1 1 1 1 1 1 0 1 1 1 1 1 0 1 1 1 1 1 1 1 1 1 0 0 1 1 1 1 1 0 1 1 1 1 0 1 1 1 1 1 0 1 1 1 1 1 0 0 1 1 1 1 1 1 1 1 1 0 1 1 1 1 1 1 1 1 1 1 1 1 1 0 0 1 1 1 1 1 1 1 0 1 1 1

1 1 1 1 1 1 1 1 1 1 1 1 0 0 1 1 1 0 1 1 1 1 1 1 1 0 1 1 1 1 1 1 1 1 1 1 1 0 0 1 0 0 1 1 0 1 1 1 1 1

1 1 1 1 1 1 1 1 1 1 1 0 0 1 1 1 1 1 1 1 0 0 1 1 0 0 1 1 1 1 1 1 1 1 1 0].

12. The method of any of claims 7 to 11, comprising at least one of the following features:
wherein
the first exponent matrix comprises the following set of values:

[-1 115 -1 -1 -1 -1 -1 -1 -1 101 -1 -1 -1 22 -1 -1 100 -1 -1 -1 159 -1 -1 -1 2 -1 0 -1 -1 -1 -1 -1 -1 -1 -1 -1 -1 -1 -1 -1 -1 -1 -1 -1 -1 -1 -1 -1 -1 -1 -1 115 -1 -1 -1 -1 -1 -1 -1 101 -1 -1 -1 22 -1 -1 -1 -1 100 -1 -1 -1 159 -1 -1 -1 2 -1 0 -1 -1 -1 -1 -1 -1 -1 -1 -1 -1 -1 -1 -1 -1 -1 -1 -1 -1 -1 -1 -1 -1 -1 7 -1 -1 -1 -1 57 -1 -1 1 1 -1 -1 -1 -1 -1 -1 -1 110 -1 -1 15 -1 -1 -1 -1 -1 -1 0 -1 0 -1 -1 -1 -1 -1 -1 -1 -1 -1 -1 -1 -1 -1 -1 -1 -1 -1 -1 -1 7 -1 -1 57 -1 -1 -1 -1 1 1 -1 -1 -1 -1 -1 -1 -1 110 15 -1 -1 -1 -1 -1 -1 -1 0 -1 0 -1 -1 -1 -1 -1 -1 -1 -1 -1 -1 -1 -1 -1 -1 -1 -1 -1 60 -1 -1 -1 -1 -1 -1 -1 49 74 -1 -1 -1 -1 -1 112 -1 -1 29 -1 -1 -1 -1 -1 -1 -1 -1 0 -1 0 -1 -1 -1 -1 -1 -1 -1 -1 -1 -1 -1 -1 -1 -1 -1 -1 -1 -1 60 -1 -1 -1 -1 -1 -1 49 -1 -1 74 -1 -1 -1 -1 -1 112 29 -1 -1 -1 -1 -1 -1 -1 -1 -1 -1 0 -1 0 -1 -1 -1 -1 -1 -1 -1 -1 -1 -1 -1 -1 -1 -1 -1 124 -1 106 -1 -1 -1 -1 -1 -1 107 -1 -1 -1 -1 6 -1 70 -1 -1 -1 -1 -1 -1 -1 -1 -1 -1 -1 -1 0 -1 0 -1 -1 -1 -1 -1 -1 -1 -1 -1 -1 -1 -1 -1 -1 -1 -1 124 -1 106 -1 -1 -1 -1 107 -1 -1 -1 -1 -1 -1 6 -1 70 -1 -1 -1 -1 -1 -1 -1 -1 -1 -1 -1 -1 0 -1 0 -1 -1 -1 -1 -1 -1 -1 -1 -1 -1 -1 -1 -1 81 -1 -1 -1 -1 40 -1 -1 132 -1 -1 -1 -1 45 -1 57 -1 -1 -1 -1 -1 -1 -1 -1 -1 -1 -1 -1 0 -1 0 -1 -1 -1 -1 -1 -1 -1 -1 -1 -1 -1 -1 81 -1 -1 -1 -1 -1 40 132 -1 -1 -1 -1 45 -1 57 -1 -1 -1 -1 -1 -1 -1 -1 -1 -1 -1 -1 -1 -1 -1 0 -1 0 -1 -1 -1 -1 -1 -1 -1 -1 -1 -1 -1 0 -1 -1 -1 -1 -1 -1 -1 16 -1 -1 84 -1 -1 -1 -1 101 -1 -1 -1 -1 -1 16 -1 -1 -1 -1 -1 -1 -1 -1 -1 -1 0 -1 0 -1 -1 -1 -1 -1 -1 -1 -1 -1 -1 -1 -1 0 -1 -1 -1 -1 -1 -1 16 -1 -1 -1 84 -1 -1 101 -1 -1 -1 -1 -1 16 -1 -1 -1 -1 -1 -1 -1 -1 -1 -1 -1 -1 0 -1 0 -1 -1 -1 -1 -1 -1 -1 -1 -1 -1 138 158 -1 -1 158 -1 -1 -1 -1 -1 -1 113 -1 -1 -1 -1 104 -1 -1 -1 -1 -1 -1 0 -1 -1 -1 -1 -1 -1 -1 -1 -1 -1 -1 0 -1 0 -1 -1 -1 -1 -1 -1 -1 -1 -1 138 -1 -1 158 158 -1 -1 -1 -1 -1 -1 -1 -1 113 -1 -1 104 -1 -1 -1 -1 -1 -1 -1 -1 0 -1 -1 -1 -1 -1 -1 -1 -1 -1 -1 -1 0 -1 0 -1 -1 -1 -1 -1 -1 -1 -1 -1 130 -1 -1 -1 -1 -1 -1 -1 76 114 -1 -1 -1 -1 -1 -1 144 -1 -1 -1 54 -1 -1 -1 -1 -1 -1 -1 -1 -1 -1 -1 -1 -1 -1 -1 -1 0 -1 0 -1 -1 -1 -1 -1 -1 -1 130 -1 -1 -1 -1 -1 -1 -1 76 -1 -1 114 -1 -1 -1 -1 144 -1 -1 -1 54 -1 -1 -1 -1 -1 -1 -1 -1 -1 -1 -1 -1 -1 -1 -1 -1 -1 0 -1 0 -1 -1 -1 -1 -1 -1 -1 129 -1 -1 -1 -1 -1 -1 28 -1 -1 104 -1 -1 -1 -1 -1 61 -1 -1 -1 -1 -1 65 -1 -1 -1 -1 -1 -1 -1 -1 -1 -1 -1 -1 -1 -1 -1 0 -1 0 -1 -1 -1 -1 -1 129 -1 -1 -1 -1 -1 -1 -1 28 104 -1 -1 -1 -1 -1 61 -1 -1 -1 -1 -1 65 -1 -1 -1 -1 -1 -1 -1 -1 -1 -1 -1 -1 -1 -1 -1 -1 0 -1 0 -1 -1 -1 -1 -1 -1 91 -1 -1 -1 -1 141 -1 0 -1 -1 -1 -1 -1 -1 -1 154 18 -1 -1 -1 -1 -1 -1 -1 -1 -1 -1 -1 -1 -1 -1 -1 -1 -1 -1 -1 -1 -1 -1 0 -1 0 -1 -1 -1 -1 -1 -1 91 -1 -1 141 -1 0 -1 -1 -1 -1 -1 -1 -1 154 -1 -1 18 -1 -1 -1 -1 -1 -1 -1 -1 -1 -1 -1 -1 -1 -1 -1 -1 -1 -1 -1 0 -1 0 -1 -1 4 -1 112 -1 -1 -1 -1 115 70 -1 -1 -1 -1 -1 -1 -1 -1 -1 -1 -1 24 -1 -1 -1 -1 -1 -1 -1 -1 -1 -1 -1 -1 -1 -1 -1 -1 -1 -1 -1 -1 0 -1 0 -1 -1 4 -1 112 -1 -1 115 -1 -1 70 -1 -1 -1 -1 -1 -1 -1 -1 -1 24 -1 -1 -1 -1 -1 -1 -1 -1 -1 -1 -1 -1 -1 -1 -1 -1 -1 -1 -1 -1 -1 0 -1 0 -1 49 -1 -1 -1 123 -1 -1 -1 121 -1 -1 -1 -1 55 -1 102 -1 -1 -1 -1 -1 32 -1 2 -1 -1 -1 -1 -1 -1 -1 -1 -1 -1 -1 -1 -1 -1 -1 -1 -1 -1 -1 -1 0 -1 49 -1 -1 -1 123 -1 -1 -1 121 -1 -1 -1 -1 -1 -1 55 -1 102 -1 -1 -1 -1 -1 32 -1 2 -1 -1 -1 -1 -1 -1 -1 -1 -1 -1 -1 -1 -1 -1 -1 -1 -1 -1 -1
-1 -1 0];

wherein
the first exponent matrix comprises the following set of values:

[231 -1 -1 -1 203 -1 45 -1 200 -1 318 -1 4 0 -1 -1 -1 -1 -1 -1 -1 -1 -1 -1 14 -1 115 -1 2 -1 -1 -1
220 31 -1 -1 -1 0 0 -1 -1 -1 -1 -1 -1 -1 -1 -1 120 -1 -1 -1 99 148 -1 -1 224 59 -1 -1 -1 -1 0 0 -1
-1 -1 -1 -1 -1 -1 -1 248 212 -1 -1 215 -1 -1 12 140 -1 -1 -1 -1 -1 -1 0 0 -1 -1 -1 -1 -1 -1 -1 163
-1 -1 80 265 -1 -1 91 115 -1 -1 -1 -1 -1 -1 -1 0 0 -1 -1 -1 -1 -1 -1 0 -1 -1 -1 33 -1 168 -1 203 -
1 -1 33 -1 -1 -1 -1 -1 0 0 -1 -1 -1 -1 -1 277 316 317 -1 -1 -1 226 -1 209 -1 -1 -1 0 -1 -1 -1 -1 -
1 0 0 -1 -1 -1 -1 261 -1 -1 -1 153 228 -1 -1 289 -1 109 -1 -1 -1 -1 -1 -1 -1 -1 0 0 -1 -1 -1 259 -
1 1 -1 56 209 -1 -1 123 -1 -1 131 -1 -1 -1 -1 -1 -1 -1 -1 0 0 -1 -1 -1 182 -1 283 1 -1 -1 -1 309
36 -1 -1 -1 -1 -1 -1 -1 -1 -1 -1 0 0 -1 8 224 -1 231 140 -1 -1 -1 -1 -1 49 -1 -1 -1 -1 -1 -1 -
1 -1 -1 -1 0 0 99 -1 247 -1 243 -1 -1 110 204 -1 -1 64 4 -1 -1 -1 -1 -1 -1 -1 -1 -1 0].

**13.** The method of any of claims 7 to 12, comprising at least one of the following features:

(i) further comprising:
generating the first exponent matrix by re-arranging a third exponent matrix having the same dimensions as the first exponent matrix,
wherein the third exponent matrix is re-arranged such that a position of one or more elements or one or more submatrices is changed and the re-arranged third exponent matrix contains the same elements as the first exponent matrix;
(ii) wherein

the first exponent matrix has dimensions of m x n where each of m and n is a positive integer, and
the method further comprises:
generating the first exponent matrix by performing the following matrix multiplication: A*E(H)*B,
wherein A is a permutation matrix having dimensions of m x m, B is a permutation matrix having dimensions n x n, and E(H) is a fourth exponent matrix having the same dimensions as the first exponent matrix.

**14.** An apparatus (108) comprising:

a receiver (140) configured to receive encoded data; and
one or more processors (2010) configured to:

identify, according to a code rate of 1/2 and a code block size of 7776 bits, a first binary parity check matrix for a quasi-cyclic-low-density parity-check, QC-LDPC, code, the first binary parity check matrix corresponding to a first exponent matrix; and
decode the received encoded data using the first binary parity check matrix.

**15.** The apparatus (108) of claim 14, wherein

the first exponent matrix has 1152 values, and
the one or more processors (2010) are further configured to:
generate the first exponent matrix based at least on a second exponent matrix having 288 values.

100

105

Baseband
Circuitry
110

Encoder
130

115

Transmitter
Circuitry
120

125

145

Receiver
Circuitry
140

108

Baseband
Circuitry
150

Decoder
160

EP 4 675 929 A1

FIG. 1

**Computing system 2000**

Cache
2020

Processor
2010

I/O Components
2050

Display
2070

Input Device
2080

Communication System 2040

Memory
2060

Network Interface
Device 2030

FIG. 2

300

24R      1   24(1-*R*)-1

**312**

$24(1-R)-1$

| | | |
|---|---|---|
| $A$ <br> **310** | $B$ | $T$ <br> **314** |

$24(1-R)$

| | | |
|---|---|---|
| $C$ **316** | $D$ | $E$ **320** |

**318**

FIG. 3

EP 4 675 929 A1

400

7×7 SparseMatrixCSC{Int64, Int64} with 0 stored entries:

d=-1 — 409

7×7 SparseMatrixCSC{Bool, Int64} with 7 stored entries:

d=0 — 410

7×7 SparseMatrixCSC{Bool, Int64} with 7 stored entries:

d=1 — 411

7×7 SparseMatrixCSC{Bool, Int64} with 7 stored entries:

d=2 — 412

7×7 SparseMatrixCSC{Bool, Int64} with 7 stored entries:

d=3 — 413

7×7 SparseMatrixCSC{Bool, Int64} with 7 stored entries:

d=4 — 414

7×7 SparseMatrixCSC{Bool, Int64} with 7 stored entries:

d=5 — 415

7×7 SparseMatrixCSC{Bool, Int64} with 7 stored entries:

d=6 — 416

FIG. 4

EP 4 675 929 A1

FIG. 5

FIG. 6

EP 4 675 929 A1

700

FIG. 7A

FIG. 7B

800

FIG. 8A

820

FIG. 8B

EP 4 675 929 A1

FIG. 8C

840

900

Identifying, by one or more processors of a first apparatus according to a code rate of 1/2 and a code block size of 7776 bits, a first binary parity check matrix for a quasi-cyclic-low-density parity-check (QC-LDPC) code, the first binary parity check matrix corresponding to a first exponent matrix 902

Encoding, by the one or more processors of the first apparatus, data using the first binary parity check matrix 904

Transmitting, by the one or more processors of the first apparatus, the encoded data 906

Identifying, by a second apparatus, the first binary parity check matrix 908

Receiving, by the second apparatus from the first apparatus, the encoded data 910

Decoding, by the second apparatus, the encoded data using the first binary parity check matrix 912

FIG. 9

Europäisches Patentamt

European Patent Office

Office européen des brevets

**EUROPEAN SEARCH REPORT**

**Application Number**

EP 25 18 7002

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 148 445 B1 (NOKIA SIEMENS NETWORKS SPA [IT]; NOKIA SIEMENS NETWORKS OY [FI]) 20 June 2012 (2012-06-20) | 1-5, 7-12,14, 15 | INV. H03M13/11 H04L1/00 |
| A | * abstract * <br> * paragraph [0001] - paragraph [0009] * <br> * paragraph [0015] - paragraph [0022] * <br> * paragraph [0084] - paragraph [0096] * <br> * figure 1 * | 6,13 | |
| X | LI HUAAN ET AL: "Efficient Construction of Quasi-Cyclic LDPC Codes With Multiple Lifting Sizes", IEEE COMMUNICATIONS LETTERS, IEEE SERVICE CENTER, PISCATAWAY, NJ, US, vol. 28, no. 4, 31 January 2024 (2024-01-31), pages 754-758, XP011965913, ISSN: 1089-7798, DOI: 10.1109/LCOMM.2024.3360450 [retrieved on 2024-01-31] | 1-5, 7-12,14, 15 | |
| A | * abstract * <br> * page 1, column 1, paragraph 2 - page 4, column 2, paragraph 1 * | 6,13 | TECHNICAL FIELDS SEARCHED (IPC) <br><br> H03M <br> H04L |

The present search report has been drawn up for all claims

| Place of search | Date of completion of the search | Examiner |
|---|---|---|
| The Hague | 6 November 2025 | Molinari, Fausto |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 7002

This annex lists the patent family members relating to the patent documents cited in the above-mentioned European search report.
The members are as contained in the European Patent Office EDP file on
The European Patent Office is in no way liable for these particulars which are merely given for the purpose of information.

06-11-2025

| Patent document cited in search report | Publication date | Patent family member(s) | Publication date |
|---|---|---|---|
| EP 2148445 B1 | 20-06-2012 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63667253

**Non-patent literature cited in the description**

- **RICHARDSON** ; **URBANKE**. *IEEE Transactions on Information Theory*, February 2001, vol. 47 (2)